(19) Europäisches Patentamt
European Patent Office
Office européen des brevets

(11) EP 3 163 706 B1

(12) **EUROPEAN PATENT SPECIFICATION**

(45) Date of publication and mention of the grant of the patent:
**06.11.2019 Bulletin 2019/45**

(21) Application number: **15814491.5**

(22) Date of filing: **11.05.2015**

(51) Int Cl.:
***H02J 3/06*** *(2006.01)* ***H02J 3/16*** *(2006.01)*
***H02J 13/00*** *(2006.01)* ***H02J 3/38*** *(2006.01)*

(86) International application number:
**PCT/JP2015/063409**

(87) International publication number:
**WO 2016/002339 (07.01.2016 Gazette 2016/01)**

(54) **VOLTAGE STABILITY MONITORING DEVICE AND METHOD**

VORRICHTUNG UND VERFAHREN ZUR ÜBERWACHUNG DER SPANNUNGSSTABILITÄT

DISPOSITIF ET PROCÉDÉ DE SURVEILLANCE DE LA STABILITÉ D'UNE TENSION

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **30.06.2014 JP 2014133508**

(43) Date of publication of application:
**03.05.2017 Bulletin 2017/18**

(73) Proprietor: **Hitachi, Ltd.**
**Chiyoda-ku**
**Tokyo 100-8280 (JP)**

(72) Inventors:
- **KURODA Eisuke**
  **Tokyo 100-8280 (JP)**
- **SATO Yasuo**
  **Tokyo 100-8280 (JP)**
- **TOMOBE Osamu**
  **Tokyo 100-8280 (JP)**
- **YAMAZAKI Jun**
  **Tokyo 100-8280 (JP)**
- **YATSU Masahiro**
  **Tokyo 100-8280 (JP)**
- **MIYOSHI Haruki**
  **Tokyo 100-8280 (JP)**

(74) Representative: **MERH-IP Matias Erny Reichl Hoffmann**
**Patentanwälte PartG mbB**
**Paul-Heyse-Strasse 29**
**80336 München (DE)**

(56) References cited:
**WO-A1-2013/030897**
**WO-A1-2013/030897**
**JP-A- H06 296 327**
**JP-A- H06 296 327**
**JP-A- H07 163 053**
**JP-A- H07 163 053**
**US-A1- 2014 148 962**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

EP 3 163 706 B1

## Description

Technical Field

The present invention relates to a voltage stability monitoring device for monitoring power stability of an electric power system.

Background Art

In the related art, in an electric power system, it is expected that a large amount of a power source (output variation type power source) in which the output is varied depending on the weather including a renewable energy (solar power generation, wind power generation, or the like) is introduced. In addition, in the recent year, as a result of progressive liberalization of electric power in many countries, business investment of the electric power system is suppressed, and an electric power flow in the existing transmission line is increased (heavy current flows). When the flow variation (flow change) is increased in a heavy flow state, there is a possibility that voltage stability of the electric power system is degraded. Furthermore, when a failure occurs in the system due to lightning strike or the like, the voltage stability of the electric power system may deteriorate. A voltage stability monitoring device which can present voltage stability improvement countermeasure to a system operator by accurately monitoring such a deterioration phenomenon of the voltage stability is required.

For example, as a background art of the present technical disclosure filed, a paper that SUZUKI Mamoru, KISHIDA Yukio: "Voltage Stability Online Monitoring System", Electrical Engineers of Japan. B, 111(3), 1991 (NPL 1) is known. In this comment paper, "Online constant period monitoring function" or "Stability determination function at peak load" are described (refer to page 248 to page 251).

In addition, as the background art of the present technical disclosure filed, JP-A-7-163053 (PTL 1) is known. This publication describes that "there is provided calculation means for calculating a monitoring index of voltage stability in a current state of an electric power system, calculation means for calculating a phase modifying insertion effect amount when the phase modifying facility to be controlled as a voltage stability countermeasure is adjusted, means for automatically selecting the phase modifying facility that exhibits the greatest effect among the phase modifying insertion effect amounts which is calculated with respect to the most unstable point that is the minimum index in a voltage stability monitoring index, flow calculation means for calculating a system state after the adjustment of the selected phase modifying facility is implemented, means for displaying the system state which is obtained through the flow calculation, and display means for automatically selecting the system state after the adjustment of the phase modifying facility that is the most effective for the most unstable point of the voltage stability, for the phase modifying inserting effect amount with respect to the most unstable point, and increasing in the voltage stability is implemented and for successively displaying the selected state at a constant interval." (refer to Abstract).

In addition, as the background art of the present technical disclosure filed, JP-A-2011-115024 (PTL 2) is known. This publication describes that "electric power system information input means 1 for inputting system information relating to an electric power system, state estimation means 2 for estimating state variables of the electric power system based on the system information, supply and demand increase scenario generation means 3 for generating a generator output change scenario of a generator belonging to the electric power system and a load increase scenario of a load belonging to the electric power system based on the state variables, optimum flow calculation means 4 for obtaining optimize state variables which are obtained by optimizing the state variables so as to minimize a predetermined target function in the generator output change scenario and the load increase scenario, multi-root analyzing means 5 for obtaining a lower solution of a P-V curve based on the optimized state variables, and ΔP calculation means 6 for calculating a voltage stability margin ΔP from the P-V curve are included." (refer to Abstract).

In addition, as the background art of the present technical disclosure JP-A-2005-287128 (PTL 3) is known. This publication describes that "system state estimation means for performing a flow calculation using system information to be input to a electric calculator 4 through information transmission devices 21, 22, or the like and estimating a node voltage, the phase angle thereof, and the power demand amount as a system state value, stability limit calculation means for estimating a PV curve indicating a relationship between the electric power demand amount and the system voltage by a continuous method by using the estimated system state as an initial value and determining a stability limit of the system voltage by determining the stability of a solution on the PV curve by a unique value calculation, stability determination means for determining the voltage stability using the determined stability limit, and output means for outputting various data items as the calculation result by each means to a man-machine interface device 5 are included." (refer to Abstract).

In addition, as the background art of the present technical disclosure filed, JP-A-9-512698 (PTL 4) is known. This publication describes that "a method for executing an evaluation of the reliability of voltage stability with respect to a region of a transmission system including a plurality of buses and a plurality of invalid storage sources which are connected to the plurality of buses is provided. The plurality of buses are grouped into a plurality of voltage control areas such that each bus in each voltage control area has substantially the same invalidity limit and the voltage in a minimum value of the relationship between the corresponding reactive power and the voltage. A corresponding invalidity storage container is determined for each of the at least one voltage control area. The invalid storage container includes at least one invalidity storage source which is selected based on a measure of the invalidity accumulation which is depleted at a predetermined operation point of a transmission system. An analysis of a single contingency is executed by calculating the corresponding amount of the invalid storage container in response to each of multiple single contingencies. The above-described corresponding amount represents a reduction in the invalidity accumulation in the invalid storage container. The analyses of a number of contingencies are executed for each invalid storage container using the single contingency such that the corresponding amount exceeds a predetermined threshold." (refer to Abstract).

In addition, as the background art of the present technical disclosure filed, JP-A-9-512699 (PTL 5) is known. This publication describes that "a method for disposing improvement means for improving the reliability of voltage stability for a region of an electric transmission system including a plurality of buses and a plurality of invalid storage sources which are connected to the plurality of buses is provided. The plurality of buses are grouped into a plurality of voltage control areas such that each bus in the voltage control area has the same corresponding relationship between a reactive power voltage and a voltage. A first voltage control area for disposing first improvement means is determined and the first voltage control area indicates a difference in an internal invalidity loss exceeding a loss threshold. Furthermore, a second voltage control area for disposing second improvement means is determined and the second voltage control area for disposing the second improvement means indicates a difference in invalidity accumulation exceeding the invalidity accumulation threshold. The first improvement means and second improvement means include a switchable shunt capacitor, a synchronous voltage capacitor, a static var component, or a combination thereof. Furthermore, third improvement means including a series capacitor, a parallel line, and a combination thereof is disposed at an interface between two adjacent voltage control areas which are determined to indicate a difference in reactive power loss or reactive power flow exceeding a predetermined threshold." (refer to Abstract).

Citation List

Patent Literature

PTL 1: JP-A-7-163053

PTL 2: JP-A-2011-115024

PTL 3: JP-A-2005-287128

PTL 4: JP-A-9-512698

PTL 5: JP-A-9-512699

US 2014/148962 A1 relates to a system and method for modeling, controlling and analyzing electrical grids for use by control room operators and automatic control provides a multi-dimensional, multilayer cellular computational network (CCN) comprising an information layer; a knowledge layer; a decision-making layer; and an action layer; wherein each said layer of said CCN represents one of a variable in an electric power system.

JP H07 163053 A relates to the task to accurately and easily recognize the weakest points of a system, wherein control countermeasures and system condition after countermeasures are made without any complicated operation of man-machine equipment performed by an operator, by automatically selecting the most unstable point of current system condition and an adjustment method for effective phase modification equipment to display them.

Non-Patent Literature

NPL 1: SUZUKI Mamoru, KISHIDA Yukio: "Voltage Stability Online Monitoring System", Electrical Engineers of Japan. B, 111(3), 1991

## Summary of Invention

### Technical Problem

Since the output of the renewable energy steeply varies with time due to the weather, a deterioration area of the voltage stability also steeply changes with time. However, in the monitoring techniques of the voltage stability described in the above-described patent literature and non-patent literature, it is not assumed of a times-series output change of the renewable energy. Therefore, the voltage stability may deteriorate during a constant period, and current or future voltage stability cannot be accurately monitored. In addition, as a result of not being accurately monitored, there is a possibility that an improper voltage stability improvement countermeasure is performed.

### Solution to Problem

In order to solve the above problems, the present invention provieds a voltage stability monitoring device and method according to the independent claims

According to the present Invention, since the assumed change scenario is automatically calculated by referring to the output variation prediction of the renewable energy and a suggestion of the voltage stability improvement countermeasure is dynamically displayed together with the effect in a case where the voltage stability improvement measures is required through the voltage stability improvement countermeasure search calculation and the time-series voltage stability calculation for the assumed change scenario, it is possible to accurately monitor current and future voltage stability of the electric power system to be monitored.

## Brief Description of Drawings

Fig. 1 illustrates an example of an overall configuration diagram of a voltage stability monitoring device.

Fig. 2 illustrates an example of an overall configuration diagram of a hardware configuration and an electric power system of the voltage stability monitoring device.

Fig. 3 illustrates an example of a configuration diagram illustrating a content of program data of the voltage stability monitoring device.

Fig. 4 is a diagram illustrating an example of renewable energy output variation prediction data.

Fig. 5 is a diagram illustrating an example of renewable energy output margin data.

Fig. 6 is a diagram illustrating an example of assumed change scenario data.

Fig. 7 is a diagram illustrating an example of voltage stability improvement countermeasure threshold value data.

Fig. 8 illustrates an example of a flow chart of entire processes of the voltage stability monitoring device.

Fig. 9 illustrates an example of a flow chart for illustrating a process of an assumed change scenario calculation unit.

Fig. 10 is illustrates an example of a flow chart for illustrating a process of a time-series voltage stability calculation.

Fig. 11 illustrates an example of a diagram illustrating a voltage stability calculation result and a voltage stability margin calculation result using a V-Q curve.

Fig. 12 illustrates an example of a diagram illustrating a time-series voltage stability calculation result and the voltage stability margin calculation result using the V-Q curve.

Fig. 13 illustrates an example of a flow chart for illustrating a process of a voltage stability improvement countermeasure necessity determination.

Fig. 14 illustrates an example of a diagram illustrating a process for calculating a degree of deviation from before change to after assumed change using the V-Q curve.

Fig. 15 illustrates an example of a diagram illustrating a process for calculating a degree of deviation from before change of a time series to after assumed change using the V-Q curve.

Fig. 16 illustrates an example of a diagram illustrating voltage stability improvement countermeasure necessity determination result data.

Fig. 17 illustrates an example of a flow chart for illustrating a process of a voltage stability improvement countermeasure search calculation.

Fig. 18 illustrates an example of a diagram indicating a process for calculating a degree of deviation from before change during executing of an assumed control to after assumed change in addition to the degree of deviation from before change and after assumed change using the V-Q curve.

Fig. 19 illustrates an example of a diagram illustrating how much the degree of deviation is improved during implementing the assumed control.

Fig. 20 illustrates an example of a diagram illustrating a location of a recommended controlled device in an electric power system for a voltage stability improvement countermeasure search result.

Fig. 21 illustrates a diagram illustrating an example of a screen for displaying a voltage stability calculation result, a voltage stability margin calculation result, and a degree of deviation from before change to after change, as a voltage stability monitoring status.

Fig. 22 illustrates a diagram illustrating an example of a screen for displaying a time-series voltage stability calculation result, a voltage stability margin calculation result, and a degree of deviation from before change to after assumed change, as a voltage stability monitoring status.

Fig. 23 illustrates a diagram illustrating an example of a screen for displaying a degree of deviation improvement rate calculation result and a recommended controlled device calculation result.

## Description of Embodiments

Hereinafter, preferred embodiments for carrying out the present invention will be described. The followings are merely examples, and are not intended to intend that the invention itself is not limited to the following specific content.

### Example 1

In the present example, regarding an example of a voltage stability monitoring device 10 for calculating assumed change scenario using system data D1, system facility data D2, and renewable energy output variation data D5, performing a time-series voltage stability calculation using calculated assumed change scenario data D7, the assumed change scenario using system data D1, the system facility data D2, the renewable energy output variation data D5, the assumed change scenario data D7, performing a voltage stability improvement countermeasure necessity determination using threshold data D3, the assumed change scenario data D7, and time-series voltage stability calculation result data D8, performing a voltage stability improvement countermeasure search calculation using the assumed change scenario using system data D1, the system facility data D2, the threshold data D3, assumed control data D4, the renewable energy output variation data D5, renewable energy output control margin data D6, the assumed change scenario data D7, the time-series voltage stability calculation result data D8, and voltage stability improvement countermeasure necessity determination result data D9, and performing a screen display of a time-series voltage stability calculation result, a voltage stability margin calculation result, a degree of deviation from before change to after assumed change, a degree of deviation improvement rate calculation result, and a recommended controlled device calculation result, as a voltage stability monitoring status, an example of an overall configuration configured of an input and output indicating a content by a database and data and a process indicating the content by the calculation unit will be illustrated in Fig. 1, and an example of a hardware configuration of an electric power system 100, a monitoring control device 210, the voltage stability monitoring device 10, a measurement device 43, a power source 110, a load 150, a bus, an electric transformer, and a transmission line will be illustrated in Fig. 2.

Fig. 1 illustrates an example of an overall configuration diagram of the voltage stability monitoring device 10 of the present example, and is a diagram illustrating a configuration of the voltage stability monitoring device 10 configured of the assumed change scenario using system data D1, the system facility data D2, the threshold data D3, the assumed control data D4, the renewable energy output variation data D5, and the renewable energy output control margin data D6, a voltage stability monitoring calculation unit 40 which is configured of an assumed change scenario calculation unit 31, a time-series voltage stability calculation unit 32, a voltage stability improvement countermeasure necessity determination unit 33, and a voltage stability improvement countermeasure search calculation unit 34, voltage stability monitoring calculation result data D41 which is configured of the assumed change scenario data D7, the time-series voltage stability calculation result data D8, and the voltage stability improvement countermeasure necessity determination result data D9, and a display unit 11.

The input data of the voltage stability monitoring device 10 is configured of the assumed change scenario using system data D1, the system facility data D2, the threshold data D3, the assumed control data D4, the renewable- energy output variation data D5, and the renewable energy output control margin data D6. In the assumed change scenario calculation unit 31 of the voltage stability monitoring device 10, the assumed change scenario data D7 is calculated using the assumed change scenario using system data D1, the system facility data D2, and the renewable energy output variation data D5. In addition, in the time-series voltage stability calculation unit 32 of the voltage stability monitoring device 10, the time-series voltage stability calculation is performed using the assumed change scenario data D7, the assumed change scenario using system data D1, the system facility data D2, the renewable energy output variation data D5, and the assumed change scenario data D7 to output the time-series voltage stability calculation result data D8. In addition, in the voltage stability improvement countermeasure necessity determination unit 33 of the voltage stability monitoring device 10, the voltage stability improvement countermeasure necessity determination is performed using the threshold data D3, the assumed change scenario data D7, and the time-series voltage stability calculation result data D8 to output the voltage stability improvement countermeasure necessity determination result data D9. In addition, in the voltage stability improvement countermeasure search calculation unit 34 of the voltage stability monitoring device 10, the voltage stability improvement countermeasure search calculation is performed using the assumed change scenario using system data D1, the system facility data D2, the threshold data D3, the assumed control data D4, the renewable energy output variation data D5, the renewable energy output control margin data D6, the assumed change scenario data D7, the time-series voltage stability calculation result data D8, and the voltage stability improvement countermeasure necessity determination result data D9, and as a voltage stability monitoring status, a screen display of a time-series voltage stability calculation result, a voltage stability margin calculation result, a degree of deviation from before change to after assumed change, a degree of deviation improvement rate calculation result, and a recommended controlled device calculation result is performed.

Fig. 2 illustrates an example of a hardware configuration of the voltage stability monitoring device 10 and an overall configuration diagram of the electric power system 100 and is a diagram illustrating an example of the hardware configuration of the electric power system 100, the monitoring control device 210, the voltage stability monitoring device 10, the measurement device 43, the power source 110, the load 150, the bus, the electric transformer, and the transmission line. The electric power system 100 is configured of any one or more of a generator 110, an electric transformer 130, the measurement device 43, and the load 150 which are connected to each other through a branch (line) 140 and a node (bus) 120, and a measurement device or a controllable device (a battery, a rechargeable secondary battery, an EV storage battery, a flywheel, a phase modifying device (a static condenser (SC), a shunt reactor (ShR), a static var compensator (SVC), a static var generator (SVG), a loop power controller (LPC), and the like)) which is not illustrated in drawings.

Here, an example of the power source 110 includes a distributed power source such as a solar power generation and a wind power generation in addition to a large power source such as a thermal power generation, a hydraulic generator, or a nuclear power generator.

Here, an example of the measurement device 43 is a device (VT, PT, or CT) for measuring one or more of a node voltage V, a branch current I, a power factor Φ, an effective power P, and a reactive power Q and has a function to transmit a data measurement location identification ID and data including a built-in time stamp of the measurement device (telemeter (TM) or the like) . A device for measuring power information (phasor information of the voltage) with absolute time using GPS, phasor measurement units (PMU), or other measurement equipment may be included. It is shown that the measurement device 43 is present in the electric power system 100. However, the measurement device 43 may be disposed in the bus, the transmission line, or the like to be connected to the generator 110, the electric transformer 130, the measurement device 43, and the load 150.

Here, measurement data D1 is each of the above data items measured in the measurement device 43 and is received to a system measurement database 21 through a communication network 300. However, instead of directly receiving the system data from the measurement device 43, the system data may be received to the system measurement database 21 through the communication network 300 after the system data items are aggregated in the monitoring control device 210 and may be received to the system measurement database 21 through the communication network 300 from both the measurement device 43 and the monitoring control device 210. The measurement data D1 may include a unique number for identifying the data items and a time stamp.

A configuration of the voltage stability monitoring device 10 will be described. The display unit 11, an input unit 12 such as a keyboard or a mouse, a communication unit 13, a computer or a calculator server (central processing unit (CPU)) 14, a memory 15, and various types of databases (a program database 20, the system measurement database 21, a system facility database 22, a threshold database 23, an assumed control database 24, a renewable energy output variation prediction database 25, a renewable energy output control margin database 26, an assumed change scenario database 27, a time-series voltage stability calculation result database 28, a voltage stability improvement countermeasure necessity determination result database 29, and an improvement countermeasure search result database 30) are connected to a bus line 42. The display unit 11 is configured as a display device, for example.

The display unit 11 may be configured using a printer device or a sound output device instead of a display device or with the display device, for example. The input unit 12 can be configured including at least one of a pointing device such as a keyboard or a mouse, a touch panel, and a sound instruction device, for example.
The communication unit 13 includes a circuit and a communication protocol for connecting to the communication network 300. The CPU 14 reads a predetermined computer program from the program database 20 and executes the program. The CPU 14 may be configured as one or a plurality of semiconductor chips and may be configured as a computer device such as a calculation server. The memory 15 is configured as a random access memory (RAM), for example, stores a computer program read from the program database 20 or stores calculation result data, image data, or the like required for each process. The screen data stored in the memory 14 is transmitted to the display unit 11 and displayed. An example of the screen to be displayed will be described.

Here, a storage content of the program database 20 will be described with reference to Fig. 3. Fig. 3 illustrates an example of a configuration diagram illustrating a content of program data of the voltage stability monitoring device. For example, a state estimation calculation program P60, an assumed change scenario calculation program P10, a time-series voltage stability calculation program P20, a voltage stability improvement countermeasure necessity determination program P30, a voltage stability improvement countermeasure search calculation program P40, and a screen display program P50 are stored in the program database 20.

Returning to Fig. 2, the CPU 14 executes the calculation programs (the state estimation calculation program P60, the assumed change scenario calculation program P10, the time-series voltage stability calculation program P20, the voltage stability improvement countermeasure necessity determination program P30, the voltage stability improvement countermeasure search calculation program P40, and the a screen display program P50) read in the memory 14 from the program database 20 and performs a calculation of a likeliable system state, a calculation of the assumed change scenario, a calculation of the time-series voltage stability (may include a calculation of a voltage stability margin), a voltage stability improvement countermeasure necessity determination, a calculation of the voltage stability improvement countermeasure search, various types of screen displays, an instruction of image data to be displayed, a search of data in various types of databases, or the like. The memory 14 is a memory for temporarily storing calculation temporary data such as image data for displaying, measurement (monitoring) data, or monitoring result data and calculation result data. The necessary image data is generated by the CPU 14 and is displayed on the display unit 11 (for example, a display screen) . The display unit 11 of the voltage stability monitoring device 10 may be a simple screen only for performing a rewriting each control program or database.

Databases roughly divided into 11 databases are stored in the voltage stability monitoring device 10. The system measurement database 21, the system facility database 22, the threshold database 23, the assumed control database 24, the renewable energy output variation prediction database 25, the renewable energy output control margin database 26, the assumed change scenario database 27, the time-series voltage stability calculation result database 28, the voltage stability improvement countermeasure necessity determination result database 29, and the improvement countermeasure search result database 30 will be described excluding the program database 20.

The effective power P, the reactive power Q, the voltage V, a voltage phase angle $\delta$, the current I, the power factor $\Phi$, and the like are included in the system measurement database 21 as system measurement data. Data with a time stamp or PMU data may be used. For example, a voltage and a voltage phase angle in a node 120a or 120b to be connected to the electric power system 100, a line flow (P+jQ) of a branch 140a or 140b to be connected to the node 120a or 120b to be connected to the electric power system 100, a line flow (P+jQ) of an electric transformer 130a or 130b to be connected to the node 120a or 120b to be connected to the electric power system 100, the voltage V and the voltage phase angle $\delta$ of a node 121a or 121b to be connected to the electric transformer 130a or 130b, the effective power P, the reactive power Q, or the power factor $\Phi$ of the load 150 or the power source 110 to be connected to the node 121a or 121b, and the effective power P, the reactive power Q, the power factor $\Phi$, the voltage V and the voltage phase angle $\delta$ of the other node, branch, power source, load, controlled device, or the like to be connected to the electric power system 100 for performing a measurement through the communication network from the measurement device 43, the monitoring control device 210, or the like. The voltage phase angle $\delta$ may be measured using the other measurement device using the PMU or GPS. The measurement device is the VT, PT, or the like. The line flow (P+jQ) can be calculated from the current I, the voltage V, and the power factor $\Phi$ which are measured by the VT or PT. In addition, a result that is a calculation result of the state estimation calculation program P60 in which the effective power P, the reactive power Q, the voltage V, the voltage phase angle $\delta$, the current I, and the power factor $\Phi$ of each of the node, the branch, the generator, the load, and the controlled device of the most preferred system is estimated and calculated is also saved as the system measurement data.

A system configuration, a line impedance (R+jX), a ground capacitance (admittance: Y), data necessary for the system configuration and the state estimation (threshold value of bad data), generator data, and data necessary for the other flow calculation, state estimation and voltage stability calculation are included in the system facility database 22. The measurement value may be obtained from a monitoring control device, a central power supply command station, or EMS and may be directly obtained from the measurement device of the entire system. When data is input manually, the data is manually input and stored by the input unit 12. When the input is performed, the necessary image data is generated by the CPU 14 and is displayed on the display unit 11. When the input is performed, it may be set a semi-manual input such that a large amount of data can be set using a complementary function.

As illustrated in Fig. 7, a determination threshold value (voltage stability improvement countermeasure threshold value) of a rate of deviation (to be described) for determining voltage stability improvement countermeasure necessity is stored in the threshold database 23. The voltage stability improvement countermeasure threshold value is a threshold value to be used in the voltage stability improvement countermeasure necessity determination and is used for selecting as a rough assumed change scenario having the voltage stability improvement countermeasure threshold value or less.

One or more of a connection node, a current output, a rated output and a capacity, an output control margin, and the like of a device (a battery, a rechargeable secondary battery, an EV storage battery, a flywheel, a phase modifying device (a static condenser (SC), a shunt reactor (ShR), a static var compensator (SVC), a static C var generator (SVG), a loop power controller (LPC), and the like)) in which the voltage stability improvement countermeasure can be performed and controlled and is saved in the assumed control database 24. These data items may be used using the 12 of the voltage stability monitoring device 10 and may be stored from the system measurement data or the system facility data.

As illustrated in Fig. 4, an output variation width where a target renewable energy for generating the assumed change scenario is predicted after T1 seconds and an output variation width where the target renewable energy is predicted after T2 seconds are stored in the renewable energy output variation prediction database 25. The T1 and T2 may be stored using the input unit 12 of the voltage stability monitoring device 10 and may be received through the communication network 300 from the monitoring control device 210. The renewable energy output variation includes an output variation amount or the like of the solar power generation, the wind power generation, a mega solar or a wind farm.

As illustrated in Fig. 5, an indication that how much the output of the renewable energy for performing the voltage stability countermeasure search can be currently (at a time of measuring) controlled and an indication that how much of the output of the renewable energy can be controlled among the output variation widths to be predicted after T1 seconds are stored in the renewable energy output control margin database 26. The current and the T1 may be stored using the input unit 12 of the voltage stability monitoring device 10 and may be received through the communication network 300 from the monitoring control device 210.

As illustrated in Fig. 6, an indication that how much of the output of the renewable energy for performing the calculation of the time-series voltage stability is varied from the current (at a time point of measuring) and after T1 seconds and the after T2 seconds is stored in the assumed change scenario database 27. The assumed change scenario data is to be calculated by the assumed change scenario calculation program P10. In Fig. 6, the assumed change is set as the output variation of the target renewable energy. However, a fault location and a failure mode may be incorporated as an assumed change as a fault case assumed in the electric power system stored using the input unit 12 of the voltage stability monitoring device 10. As the other elements, a failure removing timing or the like is included in a list. The renewable energy output variation includes simultaneous dropouts of wind farm. As the failure case, it may be only a rough failure case depending on an operation of the system. The assumed change scenario data D7 may be set in advance without using the input unit 12 or may be set the value set in the monitoring control device 210 through the communication network 300 and the communication unit 13. By these setting methods, there is an effect that it is possible to flexibly set the assumed change scenario data D7.

A time-series calculation result of a continuous type flow calculation for evaluating the voltage stability which is calculated by the time-series voltage stability calculation program P20 is stored in the time-series voltage stability calculation result database 28. For example, a V-Q curve illustrated in Fig. 11 or Fig. 12 is included. The V-Q curve is calculated for each node. In addition to the V-Q curve, there is a P-V curve for each node. The continuous type flow calculation is a method for describing the V-Q curve or the P-V curve by continuously calculating operations of a calculation (predictor calculation) for predicting a system state by changing the load power or the like under a certain constant condition and obtaining a correspond bus line voltage by the type flow calculation (corrector calculation). The detailed continuous type flow calculation will be described. For example, in a case of the V-Q curve, the time-series voltage stability calculation may be a change of the node voltage for a demand of each node and may be a change of the node voltage for the demand of each node divided by the initial demand of each node. The change of the node voltage with respect to any one of demand or a plurality of demands is saved. In addition, in the time-series voltage stability calculation result database 28, a reactive power margin $\Delta Q$ is stored for each node from the difference from a bottom to the zero of the reactive power Q of the V-Q curve to be calculated as illustrated in Fig. 11 using the V-Q curve of the voltage stability calculation result data D4 which is calculated by the time-series voltage stability calculation program P20. In the same manner of the time-series voltage stability calculation, the voltage stability margin, in also the voltage stability margin, for example, the V-Q curve to be used when obtaining the reactive power margin $\Delta Q$ from the V-Q curve may be a change of the node voltage for the demand of each node and the demand of each node may be a change of the node voltage for a demand divided by an initial demand of each node. The V-Q curve, the voltage lower than the reactive power limitation is defined as a non-stable. In addition, as the evaluation of other than the $\Delta Q$ of the V-Q curve, a method is performed according to a determining method or an evaluation method described in WECC "Voltage Stability Criteria, Undervoltage Load Shedding Strategy, and Reactive Power Reserve Monitoring Methodology", Final Report, 1998, pp. 33 to 58, and Power System Stability Operation Technical Committee: "Power system Stability Operational Technique", the electric cooperative research, Vol. 47, No. 1, 1991, pp. 24 to 34.

A result in which the degree of deviation of each node of the assumed change scenario as illustrated in Fig. 14 or Fig. 15 and the rough assumed change scenario in which the degree of the deviation is less than the threshold value as illustrated in Fig. 16 are extracted which is calculated by voltage stability improvement countermeasure necessity determination program P30 using the threshold data D3, the assumed change scenario data D7, and the time-series voltage stability calculation result data D8 is stored in the voltage stability improvement countermeasure necessity determination result database 29.

An improvement result after controlling of the degree of the deviation of each node of the each assumed change scenario as illustrated in Fig. 18 and a result in which the improvement rate of the degree of the deviation of the assumed control in each scenario as illustrated in Fig. 19 which are calculated by the voltage stability improvement countermeasure search calculation program P40 using the assumed change scenario using system data D1, the system facility data D2, the threshold data D3, the assumed control data D4, the renewable energy output variation data D5, the renewable energy output control margin data D6, the assumed change scenario data D7, the time-series voltage stability calculation result data D8, and the voltage stability improvement countermeasure necessity determination result data D9 are stored in voltage stability the improvement countermeasure search result database 30.

Next, a calculation process content of the voltage stability monitoring device 10 will be described with reference to Fig. 8. Fig. 8 illustrates a flow chart of the entire processes of the voltage stability monitoring device. Firstly, a simple flow will be described. After the system facility data D2, the threshold data D3, and the assumed control data D4 are input and stored, the system measurement data D1, the renewable energy output variation data D5, and the renewable energy output control margin data D6 are received, the state estimation calculation is performed, and the state estimation calculation result is stored. Next, the assumed change scenario is calculated using the system measurement data D1, the system facility data D2, the renewable energy output variation data D5, and the state estimation result (to be stored in the system measurement database 21) (to be stored in the assumed change scenario database 27). Next, after the time-series voltage stability calculation is performed using the calculated assumed change scenario data D7, the system measurement data D1, the system facility data D2, the renewable energy output variation data D5, and the assumed change scenario data D7, the voltage stability margin is calculated, and the voltage stability calculation result and the voltage stability margin calculation result are stored (the time-series voltage stability calculation result database 28) . The voltage stability improvement countermeasure necessity determination is performed using the threshold data D3, the assumed change scenario data D7, and the time-series voltage stability calculation result data D8, and the voltage stability improvement countermeasure necessity determination result is stored (the voltage stability improvement countermeasure necessity determination result database 29). Next, the voltage stability improvement countermeasure search calculation is performed using the system measurement data D1, the system facility data D2, the threshold data D3, the assumed control data D4, the renewable energy output variation data D5, the renewable energy output control margin data D6, the assumed change scenario data D7, the time-series voltage stability calculation result data D8, and the voltage stability improvement countermeasure necessity determination result data D9, voltage stability improvement countermeasure search result data D10 is stored (the voltage stability improvement countermeasure search result database 30). Finally, as the voltage stability monitoring status, a screen display of the voltage stability improvement countermeasure search result data D10 that is the time-series voltage stability calculation result D8, the degree of deviation from before change and after assumed change, the degree of deviation improvement rate calculation result, and the recommended controlled device calculation result is performed. The various types of calculation results or data accumulated in the memory during the calculation may be sequentially displayed on the screen of the monitoring control device 210. Accordingly, an operator can easily grasp the operational status of the voltage stability monitoring device 10. In addition, in the voltage stability monitoring device 10, as the operational status, monitoring contents (the system data receiving, the present and absent of the voltage stability monitoring calculation end, the degree of deviation, the voltage stability calculation result after T1 seconds and T2 seconds) and the like may be displayed. Accordingly, an operator can easily grasp the operational status of the voltage stability monitoring device 10. The screen display of the status from the receiving of various types of data items to the transmitting of the various types of calculation results respectively is repeated, until the change of the monitoring location is executed. Above process flows will be described for each step.

Firstly, in Step S1, in a case where the system facility data D2, the threshold data D3, and the assumed control data D4 are not set in advance, the system facility data D2, the threshold data D3, and the assumed control data D4 are input using the input unit 12 and the display unit 11. Here, data may be input from the monitoring control device 210 through the communication network 300 and the communication unit 13, and data relating to the system facility data D2, the threshold data D3, and the assumed control data D4 held in the monitoring control device 210 or the like may be automatically received at a constant period and may be stored. In addition, in a case where the system facility data D2, the threshold data D3, and the assumed control data D4 are set in advance, the correction may be added, and the data may be used without any change.

In Step S2, the system measurement data D1, the renewable energy output variation data D5, and the renewable energy output control margin data D6 are received, and the state estimation calculation is performed, and the state estimation calculation result is stored in the system measurement database 21. By the state estimation calculation, a result in which effective power P, the reactive power Q, the voltage V, the voltage phase angle $\delta$, the current I, and the power factor $\Phi$ of each of the node, the branch, the generator, the load, and the controlled device of the most preferred system is estimated and calculated is also saved as the system measurement data. The method of the state estimation calculation is performed according to the calculation method or the like described in Lars Holten, Anders Gjelsvlk, Sverre Adam, F.F. Wu, and Wen-Hs Iung E. Liu, Comparison of Different Methods for State Estimation, IEEE Transaction on Power Systems, Vol. 3(1988), pp. 1798 to 1806.

In Step S3, the assumed change scenario calculation is performed using the system facility data D2 stored in Step S1, the system measurement data D1 stored in Step S2, the renewable energy output variation data D5, and the state estimation result which is obtained in Step S2, and the result thereof is stored in the assumed change scenario database 27. Here, a flow of the assumed change scenario calculation will be descried with reference to Fig. 9. Fig. 9 illustrates an example of a flow chart for illustrating a process of the assumed change scenario calculation unit 31. Fig. 9 illustrates a method for reading the system measurement data D1, the system facility data D2, and the renewable energy output variation data D5 through Steps S11 to S18 and repeatedly calculating the flow for selecting the renewable energy output variation predictions after selection of the assumed failure location and the mode and after T1 seconds and T2 seconds and the saving the selected renewable energy output variation prediction as the assumed change scenario D7 until the assumed failure location, the assumed failure mode, and the renewable energy output variation prediction is selected and ended. The above process flows will be descried. In Step S11, the system facility data D2 stored in Step S1, the system measurement data, D1 stored in Step S2, the renewable energy output variation data D5, and the state estimation result which is obtained in Step S2 are read in the memory 14. Although not illustrated in the drawings, an estimation failure list which is formed of the assumed failure location and the assumed failure mode is held, and is read in the memory 14. In Step S12, one of the unselected assumed failure locations is selected from the list of the assumed failure locations read in the memory 14. In Step S13, one of the unselected assumed failure modes is selected from the list of the assumed failure modes read in the memory 14. In Step S14, any one of lower and upper limit values is selected from the lower and upper limit values of the variation width of the renewable energy output variation prediction after T1 seconds read in the memory 14. In Step S14', any one of lower and upper limit values is selected from the lower and upper limit values of the variation width of the renewable energy output variation prediction after T2 seconds read in the memory 14. In Step S15, a combination of the assumed failure location and the assumed failure mode, and the renewable energy output variation prediction selected in Steps S12 to S14' is saved as one assumed change scenario D7. In Step S16, in a case where all of the lists of the renewable energy output variation prediction are not selected, the process returns to Step S14. In addition, in Step S16, in a case where all of the lists of the renewable energy output variation prediction are selected, the process proceeds to Step S17. In Step S17, in a case where all of the lists of the assumed failure mode is not selected, the process returns to Step S13. In addition, in Step S17, in a case where all of the lists of the assumed failure mode is selected, the process proceeds to Step S18. In Step S18, in a case where all of the lists of the assumed failure location are not selected, the process returns to Step S12. In addition, in Step S18, in a case where all of the lists of the assumed failure location are selected, the process is ended. Here, regarding the renewable energy output variation prediction, no output change, an output reduction (during a certain constant period) and an output increase (during a certain constant period) can be considered. However, in this time, in order to assume the severe condition, an example in which the assumed change scenario is generated using the lower and upper limit values of the output variation width is shown. In addition, the renewable energy output variation prediction may be updated based on data which is stored by manually inputting for each a constant period, in the monitoring control device, and the database. Here, as a combination of the assumed failure location and the assumed failure mode, and the renewable energy output variation prediction, a combination of only renewable energy output variation predictions is present without failure. Hereinafter, as a case without failure, the content of an example will be described. Here, an example of the assumed change scenario data D7 will be described with reference Fig. 7. As illustrated in Fig. 7, as a failure case to be assumed in the electric power system, a list in which the failure location, and the failure mode, and the renewable energy output variation prediction are combined is included. As the other elements, a failure removing timing and the like are included in a list. The renewable energy output variation prediction includes the output variation amount of the solar power generation, the wind power generation, the mega solar, or the wind farm and simultaneous dropouts of wind farm. As the failure case, it may be only a rough failure case depending on an operation of the system. The assumed change scenario data D7 may be set in advance without using the input unit 12 or may be set the value set in the monitoring control device 210 through the communication network 300 and the communication unit 13. By these setting methods, there is an effect that it is possible to flexibly set the assumed change scenario data D7.

Returning to Fig. 8, here, in Step S4, after the voltage stability calculation is performed using the state estimation calculation result and the assumed change scenario, the voltage stability calculation result is stored. The method for calculating the voltage stability is performed according to the calculation method descried, for example, PTL 3, Chiang, H.D, et al., "CPFLOW: A Practical Tool for Tracing Power System Steady-State Stationary Behavior Due to Load and Generation Variations", IEEE Trans. on Power Systems, Vol. 10, No. 2, pp. 623 to 634, 1995, VVenkataramana Ajjarap, "Computational Techniques for Voltage Stability Assessment and Control" Springer, 2006, pp. 49 to 116, or JP-A-6-153397. In addition, as the calculation method of the assumed change scenario, a method according to a method disclosed in PTL 1 or a method described in Power System Stability Operation Technical Committee: "Power system Stability Operational Technique", the electric cooperative research, Vol. 47, No. 1, 1991, pp. 24 to 34. In addition, as the evaluation method of the V-Q curve, a method is performed according to a method disclosed in Power System Stability Operation Technical Committee: "Power system Stability Operational Technique", the electric cooperative research, Vol. 47, No. 1, 1991, pp. 24 to 34 and a method described in WECC, "Voltage Stability Criteria, Under voltage Load Shedding Strategy, and Reactive Power Reserve Monitoring Methodology", Final Report, 1998, pp. 33 to 58. For example, the reactive power margin $\Delta Q$ is used. Here, a flow of the time-series voltage stability calculation will be descried with reference to Fig. 10. In Step S21, the system measurement data D1, the system facility data D2, the renewable energy output variation data D5, and the assumed change scenario data D7 are read in the memory 14. In Step S22, one of load buses is selected. Next, in Step S23, a step width is determined. Here, relating to first Step S23, as the step width, the initial value is used. From second Step S23, the step width is determined by considering the number of times it takes for corrector calculation to converge with the previous step width. In Step S24, the first step is set as the setting value or the state estimation value is set as the predictor, the process proceeds to Step S25. After the second step, a selected load bus is subjected to a PV instruction, and a point where the voltage V is reduced is set as the predictor calculation result using the step width which uses the effective power as a fixed power. In this time, the effective power may use the previous value of the convergence calculation result. Next, in Step S25, the flow calculation is performed using the point of the predictor which is calculated in Step S24 as an initial value. In the flow calculation, the convergence calculation is performed using the Newton Raphson method. Here, the condition of the convergence determination in the convergence calculation has a value which is set in advance. The Newton Raphson method is performed according to a method descried in WILLIAM. F. TINNEY, et al., "Power Flow Solution by Newton's Method", IEEE Trans. on Power Systems, Vol. PAS-86, No. 11, pp. 1449 to 1460 and 1967. In Step S26, it is determines whether Step S25 is converged within the defined convergence numbers. The maximum value of the convergence numbers is previously set. In a case of convergence, the process proceeds to Step S27, the converged voltage value is saved. In a case of un-convergence, the process proceeds to Step S28, if the step width is not minimum value, the step width is reduced, and the process returns to Step S24. In Step S27, a value which is converged by the flow calculation is saved. In addition, in Step S28, if the step width is not minimum value, the process returns to Step S23 and if the step width is the minimum value, the process proceeds to Step S29, the calculation of the load bus is not performed (however, an error message is repeated). In Step S29, it is confirmed whether all of the load buses are selected, and in a case where all of the load buses are selected, the process proceeds to Step S30. In a case where all of load buses are not selected, the process returns to Step S22, the load bus is selected. In the Step S30, the time-series voltage stability calculation result D8 is saved. According to flows in Steps S22 to S30, the V-Q curve is implemented for each assumed change scenario. By solving the continuous flow calculation, the continuous flow calculation is implemented and the V-Q curve is drawn. Here, an example of the time-series voltage stability calculation result will be described with reference to Fig. 12. Fig. 12 illustrates an example for illustrating an image of the time-series voltage stability calculation unit 31. Fig. 12 can be drawn by subtracting the reactive power supply portion from the system side from the reactive power consumption of the voltage Vi of a node i in a horizontal axis and a node i of the reactive power in a vertical axis. In addition, a time axis is provided in a depth direction, it is shown that the V-Q curve can be calculated in time-series according to the assumed change scenario. In Fig. 11, a VQ curve is present in one time section, and an operation point is defined as ($V_{i0}$, $Q_0$). Furthermore, the reactive power limit that is a limit of the voltage stability is a location of $Q_c$. The V-Q curve can be drawn by subtracting the reactive power supply portion from the system side from the reactive power consumption of the node i. A function of the voltage calculation in consideration of output enable constraint data of effective and reactive power of the generator may be included. Accordingly, the voltage stability of the electric power system closer to the reality can be reviewed. The above curves are calculated for all of the load buses.

Returning to Fig. 8, in Step S5, the voltage stability improvement countermeasure necessity determination is performed and the voltage stability improvement countermeasure necessity determination result data is stored. Here, the flow of the voltage stability improvement countermeasure necessity determination will be described with reference to Fig. 13. In Step S31, the threshold data D3, the assumed change scenario data D7, and the time-series voltage stability calculation result data D8 are read in the memory 14. In Step S32, the assumed change scenario is selected. In Step S33, the degree of deviation is calculated from the time-series voltage stability calculation result data D8 and the threshold data D3 of the assumed change scenario which is selected in Step S32. Here, the calculation example of the degree of deviation will be descried with reference to Fig. 14. Fig. 14 illustrates the V-Q curve before assumed change and after assumed change, respectively. The degree of deviation is an index indicating that how much the curve after assumed change is separated from the curve before the assumed change. When the degree of the deviation is defined as D, the degree of the deviation can be calculated by Express (1). Here, Vi represents a voltage of each node and $Q_c$ is a bottom value of the reactive power of the V-Q curve. The calculation of the degree of deviation may be performed from a difference in gradient dVi/dQ in the operational point. By using the gradient, the calculation amount can be reduced. In addition, an example in which the calculation of the degree of the deviation is performed in a time series is illustrated in Fig. 15. In a case where the degree of deviation is calculated in the time series, the calculation of the degree of deviation can be performed by further adding the degree of deviation at respective times.

$$D = \int_{Q_c}^{0} V_i dQ \qquad (1)$$

Returning to Fig. 13, in Step S34, it is determined whether the degree of deviation which is calculated in Step S33 is within the threshold range which is set in advance. When the degree of deviation is in the threshold range, the selection of the assumed change scenario of Step S32 is returned, when the value is greater than the threshold value, the process proceeds to Step S35. In Step S35, as the voltage stability improvement countermeasure necessity determination result data D9, the degree of deviation and the indication whether the degree of deviation is within the threshold value are saved. When the value is greater than the threshold value, the process proceeds to Step S35, the result that the value is within the threshold value is held in the memory 14, and when passing through Step S35, the result is saved. Here, in Fig. 16, a relationship image of the degree of deviation and the threshold value of the assumed change scenario is illustrated. In Fig. 16, the assumed change scenario No. 1 becomes a rough assumed change scenario. The number of the rough assumed scenarios is not limited to 1, and a case where there is no assumed change scenario can be included. Returning to Fig. 13, in Step S36, it is determined whether all of the assumed change scenarios are selected, and when the assumed change scenario which is not selected is present, the process returns to Step S32. When all of the assumed change scenarios are selected, the process is ended, and the process proceeds to Step S6.

Returning to Fig. 8, in Step S6, the voltage stability improvement countermeasure search calculation is performed, and the voltage stability improvement countermeasure search calculation result data is stored. Here, a flow of the voltage stability improvement countermeasure search calculation will be described with reference to Fig. 17. In Step S41, the system measurement data D1, the system facility data D2, the threshold data D3, the assumed control data D4, the renewable energy output variation data D5, the renewable energy output control margin data D6, the assumed change scenario data D7, the time-series voltage stability calculation result data D8, and the voltage stability improvement countermeasure necessity determination result data D9 are read in the memory 14. In Step S42, the assumed change scenario is selected. In Step S43, the assumed control is selected by the assumed control data. In Step S44, the time-series voltage stability calculation is executed, and in Step S45, the degree of deviation calculation is executed. Here, Fig. 18 indicates the degree of deviation in a case where the selected assumed control is executed in a form that is added in Fig. 14 which is calculated at the time of voltage stability improvement countermeasure necessity determination. The degree of deviation in the voltage stability improvement countermeasure search calculation is calculated by the same expression as the express at the time of voltage stability improvement countermeasure necessity determination. In addition, Fig. 19 illustrates whether how much the degree of deviation is improved (the degree of deviation is decreased) using the calculation before and after assumed control. Here, returning to Fig. 17, in Step S46, the voltage stability improvement countermeasure search result data D10 is saved. Next, in Step S47, it is determined whether all of the assumed controls are selected. In a case where all of the assumed controls are not selected, the process returns to Step S43 and in a case where all of the assumed controls are selected, the process proceeds to Step S48. In Step S48, it is determines whether all of the assumed change scenarios are selected. In a case where all of the assumed change scenarios are not selected, the process returns to Step S42 and in a case where all of the assumed change scenarios are selected, the process proceeds to Step S49. In Step S49, the average values in the respective assumed change scenario and the assume control are calculated and the calculated average value is held in the memory 14. In Step S50, an assumed control group having a low average value of the degrees of deviation held in the memory is determined as the voltage stability improvement countermeasure. There is a case where the number of assume control groups is zero or the number of assume control groups is one. Next, in Step S51, the voltage stability improvement countermeasure search result data D10 is saved and ended. The assume control group which is determined as the voltage stability improvement countermeasure becomes a recommended voltage stability improvement countermeasure. By illustrating a geographical position on the system diagram as illustrated in Fig. 20, an effect that it is easy to understand where voltage stability can be improved can be estimated, and the operator can easily review the countermeasure. In addition, by displaying the recommended voltage stability improvement countermeasures in the overlap manner to the plurality of assumed change scenarios of displaying the other voltage stability improvement countermeasures in the overlap manner, it is easier to grasp the tendency that which assumed change scenario is severe and the improvement rate of which assumed control is low or high. Accordingly, an effect that the operator can easily review the voltage stability improvement countermeasures.

Returning to Fig. 8, here, in final Step S7, as the voltage stability monitoring status, a screen display of the voltage stability improvement countermeasure search result data D10 that is the time-series voltage stability calculation result D8, the degree of deviation from before change and after assumed change, the degree of deviation improvement rate calculation result, and the recommended controlled device calculation result. The various types of calculation results or data accumulated in the memory during the calculation may be sequentially displayed on the screen of the monitoring control device 210. Accordingly, an operator can easily grasp the operational status of the voltage stability monitoring device 10. In addition, in the voltage stability monitoring device 10, as the operational status, monitoring contents (the system data receiving, the present and absent of the voltage stability monitoring calculation end, the degree of deviation, the voltage stability calculation result after T1 seconds and T2 seconds) and the like may be displayed. Accordingly, an operator can easily grasp the operational status of the voltage stability monitoring device 10. The screen display of the status from the receiving of various types of data items to the transmitting of the various types of calculation results respectively, until the change of the monitoring location is executed. Thereafter, the step may return to a receiving step of data of Step S2 and by returning to the input process of the data of Step S1, the input data may be corrected. By displaying the screen display as an alarm, the effect the operator's notice can be generated is achieved. On the other hand, when the alarm is issued too much, there is possibility that the failure occurs in the normal business. Accordingly, by providing a certain degree of margin, a burden on the operator can be reduced.

Next, in Figs. 21 to 23, display examples of the output screen are illustrated. Fig. 21 illustrates a diagram illustrating an example of a screen for displaying a voltage stability calculation result, a voltage stability margin calculation result, and a degree of deviation from before change to after assumed change, as a voltage stability monitoring status. By arranging the degree of deviation as a bar graph, an effect that the deterioration in the voltage stability after assumed change can be understood at once is achieved. In addition, by displaying the voltage value and the reactive power margin of each scenario when moving the designation location, the function that the user can easily view the data is included. In addition, by,displaying the reactive power margin, the operator can grasp the margin at once. In addition, several indexes of the voltage stability can be selected, and the function that can operate respective results and display on the screen may be included. Accordingly, severity of voltage stability can be easily evaluated. In addition, the function that can change the display by selecting a past history is included. Accordingly, in general, the set bus is indicated, and it is possible to confirm the V-Q curve of the other set bus. Fig. 22 illustrates a diagram illustrating an example of a screen for displaying a time-series voltage stability calculation result, a voltage stability margin calculation result, and a degree of deviation from before change to after change, as a voltage stability monitoring status. By adding a concept of the time axis to Fig. 21, an effect that a comparative evaluation of each assumed change scenario when the time is changed is easily performed is achieved. Fig. 23 illustrates a diagram illustrating an example of a screen for displaying a degree of deviation improvement rate calculation result and a recommended controlled device calculation result. By displaying the recommended control device on the system diagram in this manner, an effect that the operator can easily understand the control location can be achieved. Furthermore, a function that the different assumed change scenarios are selected with a tab, the improvement rate of the degree of deviation at this time is displayed on the screen, the content can be viewed is included. Accordingly, it is possible to easily recognize one or more positions of the recommended control device. In addition, the function that can change the display by selecting a past history is included.

Reference Signs List

10: voltage stability monitoring device
11: display unit
12: input unit
13: communication unit
14: CPU
15: memory
20: program data (program database)
21: system measurement data (system measurement database)
22: system facility data (system facility database)
23: threshold data (threshold database)
24: assumed control data (assumed control database)
25: renewable energy output variation prediction data (renewable energy output variation prediction database)
26: renewable energy output control margin data (renewable energy output control margin database)
27: assumed change scenario data (assumed change scenario database)
28: time-series voltage stability calculation result data (time-series voltage stability calculation result database)
29: voltage stability improvement countermeasure necessity determination result data (voltage stability improvement countermeasure necessity determination result database)
30: voltage stability improvement countermeasure search result data (voltage stability improvement countermeasure search result database)
31: assumed change scenario calculation unit
32: time-series-voltage stability calculation unit
33: voltage stability, improvement countermeasure necessity determination unit
34: voltage stability improvement countermeasure search calculation unit
40: voltage stability calculation unit
41: voltage stability monitoring calculation result data (voltage stability monitoring calculation result database)
42: bus line
43: measurement device
51: system measurement data

100: electric power system
110: power source (including renewable energy power source)
120a, 120b, 121a, 121b: node (bus)
130a, 130b: electric transformer
140a, 140b, 141a, 141b: branch (line)
150: load
210: monitoring control device
300: communication network
310: voltage stability monitoring screen
320: voltage stability calculation result screen of time-series, voltage stability margin calculation result screen, screen of degree of deviation from before change to after assumed change
330: degree of deviation improvement rate calculation result screen of each scenario
340 : system information screen of recommended controlled device calculation result

## Claims

**1.** A voltage stability monitoring device (10) for monitoring voltage stability of a system comprising:

an assumed change scenario calculation unit (31) configured to predict output variation of a renewable energy connected to the system and configured to calculate an assumed change time-series power flow state on the basis of the output variation;
a time-series voltage stability calculation unit (32) configured to calculate a node voltage change with respect to demand at each node of the system on the basis of the power flow state calculated by the assumed change scenario calculation unit (31) and configured to calculate a voltage stability indicating a relationship curve between the node voltage and reactive power;
a voltage stability improvement countermeasure search unit configured to determine a controlled device on which an assumed control is to be performed, according to the voltage stability calculated by the time-series voltage stability calculation unit (32); and
a voltage stability improvement countermeasure necessity determination unit (33) suitable for determining whether to perform the assumed control depending on a predetermined index to be calculated from the voltage stability, wherein the voltage stability improvement countermeasure necessity determination unit (33) is configured to calculate a degree of deviation which is obtained by integrating a difference between the relationship curves before and after the assumed change over a predetermined voltage range and is configured to determine whether to perform the assumed control depending on whether the degree of deviation is in a predetermined threshold value.

**2.** The voltage stability monitoring device (10) according to Claim 1,
wherein the assumed change scenario calculation unit (31) calculates the flow state on the basis of an assumed change including at least one of a failure location of a system device, a mode or failure releasing timing, and an output variation of a solar power generation or a wind power generation.

**3.** The voltage stability monitoring device (10) according to Claim 1, further comprising:
a display unit (11) for displaying the controlled device which is determined in the voltage stability improvement countermeasure search unit.

**4.** The voltage stability monitoring device (10) according to Claim 1,
wherein the relationship curve is calculated using a flow calculation in which a predictor calculation and a corrector calculation are repeated.

**5.** The voltage stability monitoring device (10) according to Claim 1,
wherein the relationship curve has a time axis in addition to axes of the voltage and the reactive power.

**6.** The voltage stability monitoring device (10) according to Claim 1,
wherein the controlled device on which the assumed control is to be performed when an average value of a plurality of degrees of deviation becomes lower is determined and the controlled device is displayed on a screen.

**7.** The voltage stability monitoring device (10) according to Claim 1,

wherein an improvement rate of the degree of the deviation is calculated on the basis of the degree of deviation before and after the assumed change and the degree of deviation after the assumed control is performed.

**8.** A method of monitoring voltage stability for monitoring voltage stability of a system, the method comprising:

a step for predicting output variation of a renewable energy connected to the system and calculating an assumed change time-series power flow state on the basis of the output variation;
a step for calculating a node voltage change with respect to demand at each node of the system on the basis of the power flow state and calculating a voltage stability indicating a relationship curve between the node voltage and reactive power;
a step for determining a controlled device on which an assumed control is to be performed, according to the voltage stability;
determining whether to perform the assumed control depending on a predetermined index to be calculated from the voltage stability;
calculating a degree of deviation which is obtained by integrating a difference between the relationship curves before and after the assumed change over a predetermined voltage range; and
determining whether to perform the assumed control depending on whether the degree of deviation is in a predetermined threshold value; and
a step for displaying the determined controlled device and the degree of deviation for the assumed change together with the assumed change on a screen.

**Patentansprüche**

**1.** Spannungsstabilitäts-Überwachungsvorrichtung (10) zum Überwachen der Spannungsstabilität eines Systems, die Folgendes umfasst:

eine Berechnungseinheit (31) für ein angenommenes Änderungsszenario, die konfiguriert ist, eine Ausgangsschwankung erneuerbarer Energie, die mit dem System verbunden ist, vorherzusagen, und konfiguriert ist, einen angenommenen Änderungszeitreihen-Leistungsflusszustand auf der Grundlage der Ausgangsschwankung zu berechnen;
eine Zeitreihenspannungsstabilitäts-Berechnungseinheit (32), die konfiguriert ist, eine Knotenspannungsänderung in Bezug auf einen Bedarf bei jedem Knoten des Systems auf der Grundlage des Leistungsflusszustands, der durch die Berechnungseinheit (31) für ein angenommenes Änderungsszenario berechnet wurde, zu berechnen, und konfiguriert ist, eine Spannungsstabilität zu berechnen, die eine Beziehungskurve zwischen der Knotenspannung und einer Blindleistung anzeigt;
eine Spannungsstabilitätsverbesserungs-Gegenmaßnahmensucheinheit, die konfiguriert ist, eine gesteuerte Einrichtung, auf der eine angenommene Steuerung durchgeführt werden soll, gemäß der Spannungsstabilität, die durch die Zeitreihenspannungsstabilitäts-Berechnungseinheit (32) berechnet wurde, zu bestimmen; und
eine Spannungsstabilitätsverbesserungs-Gegenmaßnahmennotwendigkeits-Bestimmungseinheit (33), die geeignet ist, zu bestimmen, ob die angenommene Steuerung abhängig von einem vorgegebenen Index, der aus der Spannungsstabilität berechnet werden soll, durchgeführt werden soll, wobei die Spannungsstabilitätsverbesserungs-Gegenmaßnahmennotwendigkeits-Bestimmungseinheit (33) konfiguriert ist, einen Grad einer Abweichung, der durch Integrieren einer Differenz zwischen den Beziehungskurve bevor und nach der angenommenen Änderung über einen vorgegebenen Spannungsbereich erhalten wird, zu berechnen, und konfiguriert ist, zu bestimmen, ob die angenommene Steuerung abhängig davon, ob der Grad der Abweichung in einem vorgegebenen Schwellenwert liegt, durchgeführt werden soll.

**2.** Spannungsstabilitäts-Überwachungsvorrichtung (10) nach Anspruch 1, wobei
die Berechnungseinheit (31) für ein angenommenes Änderungsszenario den Flusszustand auf der Grundlage einer angenommenen Änderung, die einen Fehlerort einer Systemeinrichtung, einen Modus oder einen Fehlerfreigabezeitpunkt und/oder eine Ausgangsschwankung einer Solarenergieerzeugung oder einer Windenergieerzeugung enthält, berechnet.

**3.** Spannungsstabilitäts-Überwachungsvorrichtung (10) nach Anspruch 1, die ferner Folgendes umfasst:
eine Anzeigeeinheit (11) zum Anzeigen der gesteuerten Einrichtung, die in der Spannungsstabilitätsverbesserungs-Gegenmaßnahmensucheinheit bestimmt wird.

4. Spannungsstabilitäts-Überwachungsvorrichtung (10) nach Anspruch 1, wobei die Beziehungskurve unter Verwendung einer Flussberechnung, in der eine Prädiktorberechnung und eine Korrektorberechnung wiederholt werden, berechnet wird.

5. Spannungsstabilitäts-Überwachungsvorrichtung (10) nach Anspruch 1, wobei die Beziehungskurve zusätzlich zu Achsen der Spannung und der Blindleistung eine Zeitachse besitzt.

6. Spannungsstabilitäts-Überwachungsvorrichtung (10) nach Anspruch 1, wobei die gesteuerte Einrichtung, in der die angenommene Steuerung durchgeführt werden soll, wenn ein Durchschnittswert von mehreren Graden einer Abweichung niedriger wird, bestimmt wird und die gesteuerte Einrichtung auf einem Bildschirm angezeigt wird.

7. Spannungsstabilitäts-Überwachungsvorrichtung (10) nach Anspruch 1, wobei eine Verbesserungsrate des Grads der Abweichung auf der Grundlage des Grads einer Abweichung vor und nach der angenommenen Änderung und des Grads einer Abweichung, nachdem die angenommene Steuerung durchgeführt worden ist, berechnet wird.

8. Verfahren zum Überwachen einer Spannungsstabilität, um die Spannungsstabilität eines Systems zu überwachen, wobei das Verfahren Folgendes umfasst:

einen Schritt zum Vorhersagen einer Ausgangsschwankung erneuerbarer Energie, die mit dem System verbunden ist, Berechnen eines angenommenen Änderungszeitreihen-Leistungsflusszustand auf der Grundlage der Ausgangsschwankung;
einen Schritt zum Berechnen einer Knotenspannungsänderung in Bezug auf einen Bedarf bei jedem Knoten des Systems auf der Grundlage des Leistungsflusszustands und Berechnen einer Spannungsstabilität, die eine Beziehungskurve zwischen der Knotenspannung und einer Blindleistung anzeigt;
einen Schritt zum Bestimmen einer gesteuerten Einrichtung, auf der eine angenommene Steuerung durchgeführt werden soll, gemäß der Spannungsstabilität;
Bestimmen, ob die angenommene Steuerung abhängig von einem vorgegebenen Index, der aus der Spannungsstabilität berechnet werden soll, durchgeführt werden soll;
Berechnen eines Grads einer Abweichung, der durch Integrieren einer Differenz zwischen den Beziehungskurve bevor und nach der angenommenen Änderung über einen vorgegebenen Spannungsbereich erhalten wird; und
Bestimmen, ob die angenommene Steuerung abhängig davon, ob der Grad einer Abweichung in einem vorgegebenen Schwellenwert liegt, durchgeführt werden soll; und
einen Schritt zum Anzeigen der bestimmten gesteuerten Einrichtung und des Grads einer Abweichung für die angenommene Änderung gemeinsam mit der angenommenen Änderung auf einem Bildschirm.

## Revendications

1. Dispositif de surveillance de la stabilité de tension (10) pour surveiller la stabilité de tension d'un système, comprenant :

une unité de calcul de scénario de changement supposé (31) configurée pour prédire la variation de production d'une énergie renouvelable connectée au système et configurée pour calculer un état de flux de puissance en série chronologique de changement supposé sur la base de la variation de production ;
une unité de calcul de stabilité de tension en série chronologique (32) configurée pour calculer un changement de tension de nœud par rapport à la demande à chaque nœud du système sur la base de l'état de flux de puissance calculé par l'unité de calcul de scénario de changement supposé (31) et configurée pour calculer une stabilité de tension indiquant une courbe de relation entre la tension de nœud et la puissance réactive ;
une unité de recherche de contre-mesure d'amélioration de la stabilité de tension configurée pour déterminer un dispositif commandé sur lequel une commande supposée doit être effectuée, en fonction de la stabilité de tension calculée par l'unité de calcul de stabilité de tension en série chronologique (32) ; et
une unité de détermination de nécessité de contre-mesure d'amélioration de la stabilité de tension (33) appropriée pour déterminer s'il faut effectuer la commande supposée en fonction d'un indice prédéterminé à calculer à partir de la stabilité de tension, l'unité de détermination de nécessité de contre-mesure d'amélioration de la stabilité de tension (33) étant configurée pour calculer un degré d'écart qui est obtenu en intégrant une différence entre les courbes de relation avant et après le changement supposé sur une plage de tension prédéterminée et configurée pour déterminer s'il faut effectuer la commande supposée selon que le degré d'écart est dans une valeur seuil prédéterminée.

**2.** Dispositif de surveillance de la stabilité de tension (10) selon la revendication 1,
dans lequel l'unité de calcul de scénario de changement supposé (31) calcule l'état de flux sur la base d'un changement supposé incluant au moins un changement parmi un emplacement de défaillance d'un dispositif du système, une temporisation de déblocage de défaillance ou de mode et une variation de production d'une génération d'énergie solaire ou d'une génération d'énergie éolienne.

**3.** Dispositif de surveillance de la stabilité de tension (10) selon la revendication 1, comprenant en outre :
une unité d'affichage (11) pour afficher le dispositif commandé qui est déterminé dans l'unité de recherche de contre-mesure d'amélioration de la stabilité de tension.

**4.** Dispositif de surveillance de la stabilité de tension (10) selon la revendication 1,
dans lequel la courbe de relation est calculée à l'aide d'un calcul de flux dans lequel un calcul de prédicteur et un calcul de correcteur sont répétés.

**5.** Dispositif de surveillance de la stabilité de tension (10) selon la revendication 1,
dans lequel la courbe de relation possède un axe des temps en plus des axes de la tension et de la puissance réactive.

**6.** Dispositif de surveillance de la stabilité de tension (10) selon la revendication 1,
dans lequel le dispositif commandé sur lequel la commande supposée doit être effectuée lorsqu'une valeur moyenne d'une pluralité de degrés d'écart devient plus faible est déterminée et le dispositif commandé est affiché sur un écran.

**7.** Dispositif de surveillance de la stabilité de tension (10) selon la revendication 1,
dans lequel un taux d'amélioration du degré de l'écart est calculé sur la base du degré d'écart avant et après le changement supposé et le degré d'écart après que la commande supposée est effectuée.

**8.** Procédé de surveillance de la stabilité de tension pour surveiller la stabilité de tension d'un système, le procédé comprenant :

une étape pour prédire la variation de production d'une énergie renouvelable connectée au système et calculer un état de flux de puissance en série chronologique de changement supposé sur la base de la variation de production ;
une étape pour calculer un changement de tension de nœud par rapport à la demande à chaque nœud du système sur la base de l'état de flux de puissance et calculer une stabilité de tension indiquant une courbe de relation entre la tension de nœud et la puissance réactive ;
une étape pour déterminer un dispositif commandé sur lequel une commande supposée doit être effectuée, en fonction de la stabilité de tension ;
déterminer s'il faut effectuer la commande supposée en fonction d'un indice prédéterminé à calculer à partir de la stabilité de tension ;
calculer un degré d'écart qui est obtenu en intégrant une différence entre les courbes de relation avant et après le changement supposé sur une plage de tension prédéterminée ; et
déterminer s'il faut effectuer la commande supposée selon que le degré d'écart est dans une valeur seuil prédéterminée ; et
une étape pour afficher le dispositif commandé déterminé et le degré d'écart pour le changement supposé conjointement avec le changement supposé sur un écran.

[Fig. 1]

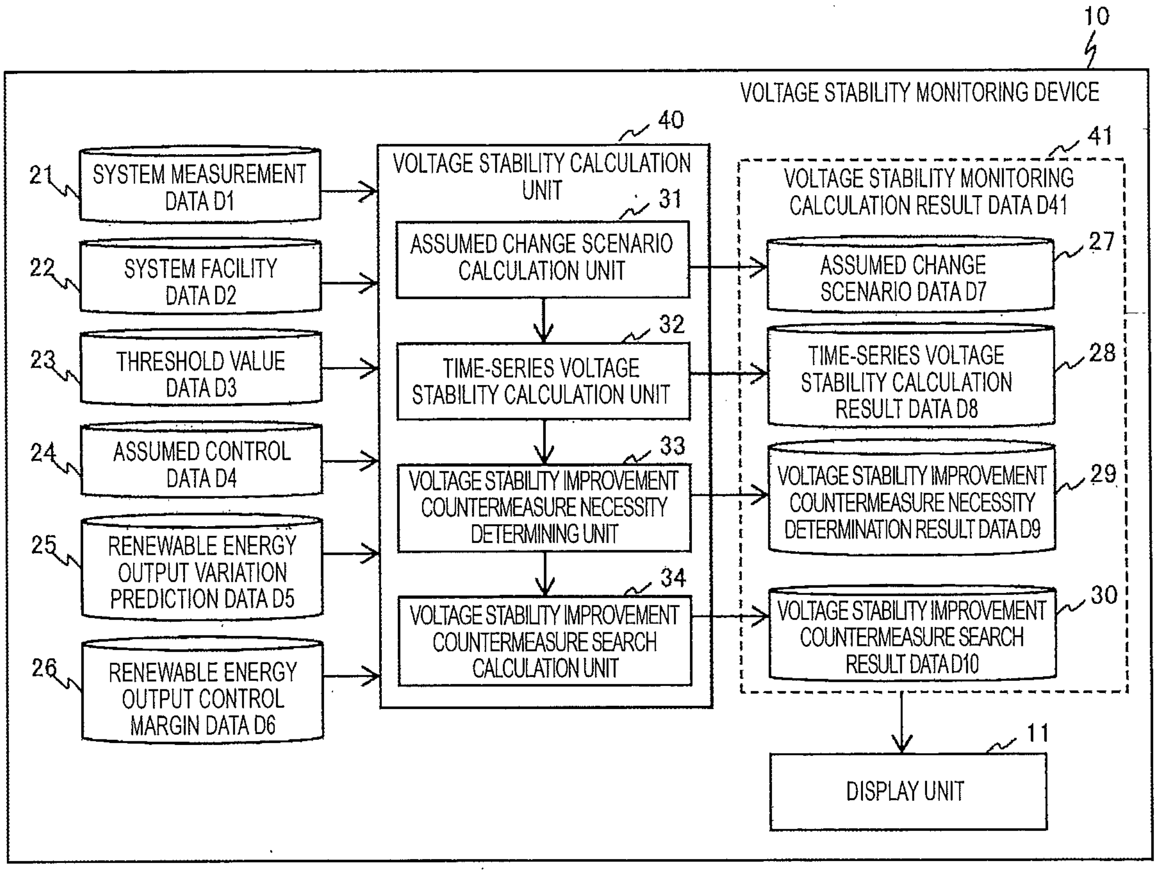
10
VOLTAGE STABILITY MONITORING DEVICE
21
SYSTEM MEASUREMENT DATA D1
22
SYSTEM FACILITY DATA D2
23
THRESHOLD VALUE DATA D3
24
ASSUMED CONTROL DATA D4
25
RENEWABLE ENERGY OUTPUT VARIATION PREDICTION DATA D5
26
RENEWABLE ENERGY OUTPUT CONTROL MARGIN DATA D6
40
VOLTAGE STABILITY CALCULATION UNIT
31
ASSUMED CHANGE SCENARIO CALCULATION UNIT
32
TIME-SERIES VOLTAGE STABILITY CALCULATION UNIT
33
VOLTAGE STABILITY IMPROVEMENT COUNTERMEASURE NECESSITY DETERMINING UNIT
34
VOLTAGE STABILITY IMPROVEMENT COUNTERMEASURE SEARCH CALCULATION UNIT
41
VOLTAGE STABILITY MONITORING CALCULATION RESULT DATA D41
27
ASSUMED CHANGE SCENARIO DATA D7
28
TIME-SERIES VOLTAGE STABILITY CALCULATION RESULT DATA D8
29
VOLTAGE STABILITY IMPROVEMENT COUNTERMEASURE NECESSITY DETERMINATION RESULT DATA D9
30
VOLTAGE STABILITY IMPROVEMENT COUNTERMEASURE SEARCH RESULT DATA D10
11
DISPLAY UNIT

[Fig. 2]

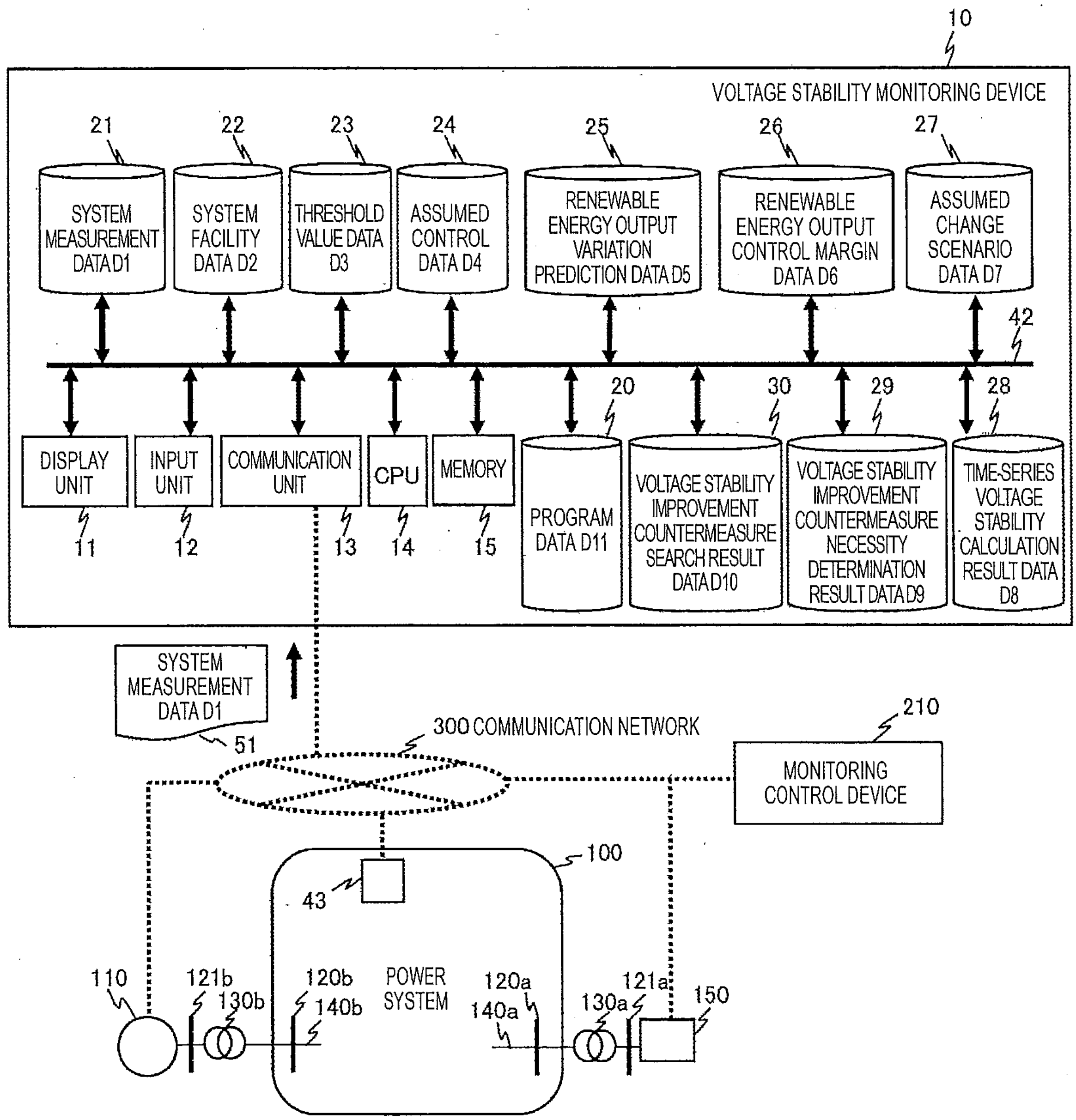
10
VOLTAGE STABILITY MONITORING DEVICE
21
SYSTEM MEASUREMENT DATA D1
22
SYSTEM FACILITY DATA D2
23
THRESHOLD VALUE DATA D3
24
ASSUMED CONTROL DATA D4
25
RENEWABLE ENERGY OUTPUT VARIATION PREDICTION DATA D5
26
RENEWABLE ENERGY OUTPUT CONTROL MARGIN DATA D6
27
ASSUMED CHANGE SCENARIO DATA D7
42
20
30
29
28
DISPLAY UNIT
11
INPUT UNIT
12
COMMUNICATION UNIT
13
CPU
14
MEMORY
15
PROGRAM DATA D11
VOLTAGE STABILITY IMPROVEMENT COUNTERMEASURE SEARCH RESULT DATA D10
VOLTAGE STABILITY IMPROVEMENT COUNTERMEASURE NECESSITY DETERMINATION RESULT DATA D9
TIME-SERIES VOLTAGE STABILITY CALCULATION RESULT DATA D8
SYSTEM MEASUREMENT DATA D1
51
300 COMMUNICATION NETWORK
210
MONITORING CONTROL DEVICE
100
43
110
121b
130b
120b
140b
POWER SYSTEM
120a
140a
130a
121a
150

[Fig. 3]

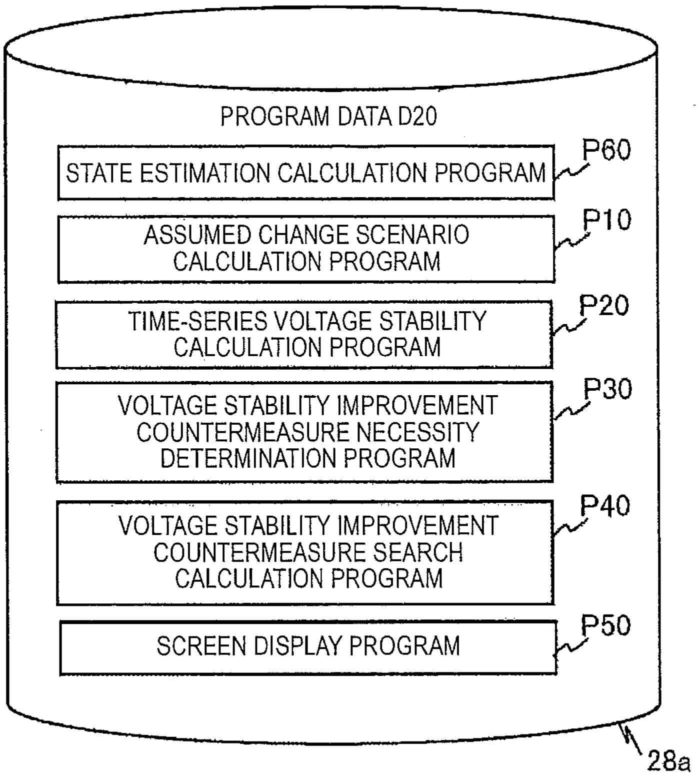


[Fig. 4]

| No. | TARGET RENEWABLE ENERGY | AFTER T1 SECONDS | AFTER T2 SECONDS | ... |
|---|---|---|---|---|
| 1 | 110a | $\pm\Delta Pa_1$ | $\pm\Delta Pa_2$ | |
| 2 | 110b | $\pm\Delta Pb_1$ | $\pm\Delta Pb_2$ | ... |
| : | : | : | : | ... |

[Fig. 5]

| No. | TARGET RENEWABLE ENERGY | CURRENT | AFTER T1 SECONDS | ... |
|---|---|---|---|---|
| 1 | 110a | $-\Delta Pa_{02}$ | $-\Delta Pa_{12}$ | |
| 2 | 110b | $+\Delta Pb_{01}$<br>$-\Delta Pb_{02}$ | $-\Delta Pb_{11}$<br>$-\Delta Pb_{12}$ | ... |
| : | : | : | : | ... |

[Fig. 6]

| No. | TARGET RENEWABLE ENERGY | CURRENT | AFTER T1 SECONDS | ... | AFTER T2 SECONDS | ... |
|---|---|---|---|---|---|---|
| 1 | 110a | − | $+\Delta Pa_1$ | ... | $+\Delta Pa_2$ | ... |
| | 110b | − | $+\Delta Pb_1$ | ... | $+\Delta Pb_2$ | ... |
| | : | : | : | ... | : | ... |
| 2 | 110a | − | $-\Delta Pa_1$ | ... | $-\Delta Pa_2$ | ... |
| | 110b | − | $-\Delta Pb_1$ | ... | $-\Delta Pb_2$ | ... |
| | : | : | : | ... | : | ... |
| : | : | : | : | : | : | ... |

[Fig. 7]

| VOLTAGE STABILITY IMPROVEMENT COUNTERMEASURE THRESHOLD VALUE [%] |
|---|
| XX.XXX |

[Fig. 8]

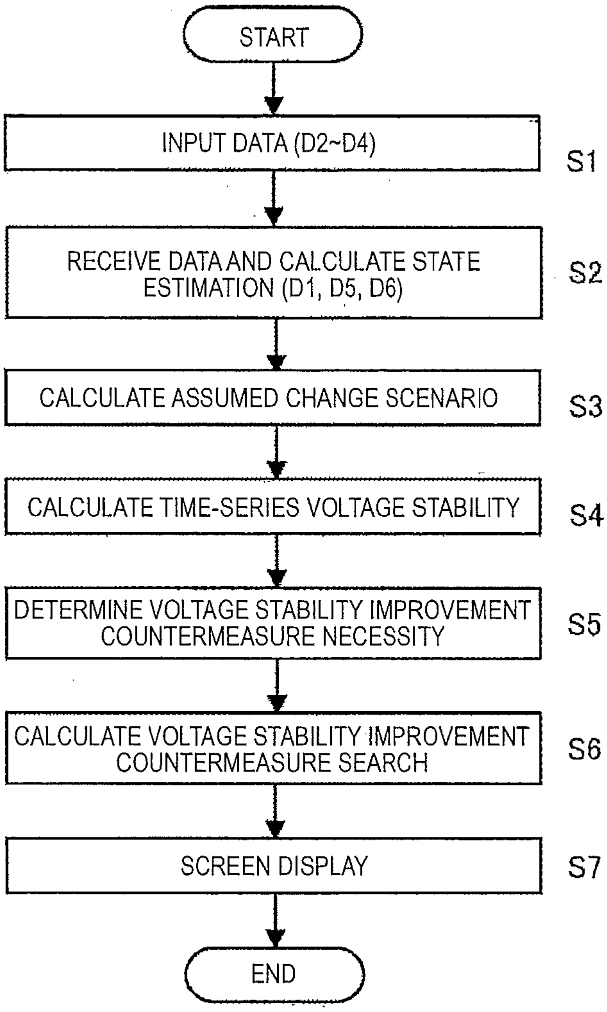
START
INPUT DATA (D2~D4)
S1
RECEIVE DATA AND CALCULATE STATE ESTIMATION (D1, D5, D6)
S2
CALCULATE ASSUMED CHANGE SCENARIO
S3
CALCULATE TIME-SERIES VOLTAGE STABILITY
S4
DETERMINE VOLTAGE STABILITY IMPROVEMENT COUNTERMEASURE NECESSITY
S5
CALCULATE VOLTAGE STABILITY IMPROVEMENT COUNTERMEASURE SEARCH
S6
SCREEN DISPLAY
S7
END

[Fig. 9]

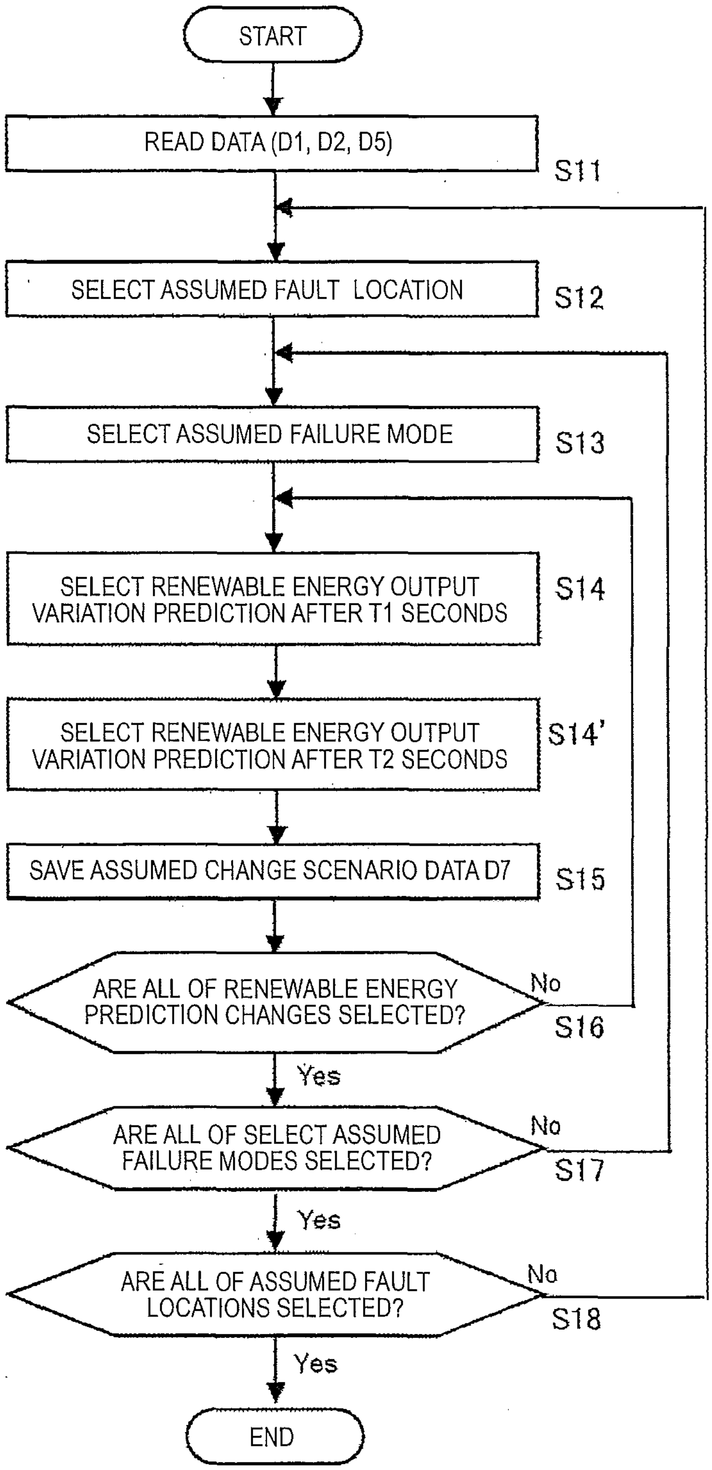
START
READ DATA (D1, D2, D5)
S11
SELECT ASSUMED FAULT LOCATION
S12
SELECT ASSUMED FAILURE MODE
S13
SELECT RENEWABLE ENERGY OUTPUT VARIATION PREDICTION AFTER T1 SECONDS
S14
SELECT RENEWABLE ENERGY OUTPUT VARIATION PREDICTION AFTER T2 SECONDS
S14'
SAVE ASSUMED CHANGE SCENARIO DATA D7
S15
ARE ALL OF RENEWABLE ENERGY PREDICTION CHANGES SELECTED?
No
S16
Yes
ARE ALL OF SELECT ASSUMED FAILURE MODES SELECTED?
No
S17
Yes
ARE ALL OF ASSUMED FAULT LOCATIONS SELECTED?
No
S18
Yes
END

[Fig. 10]

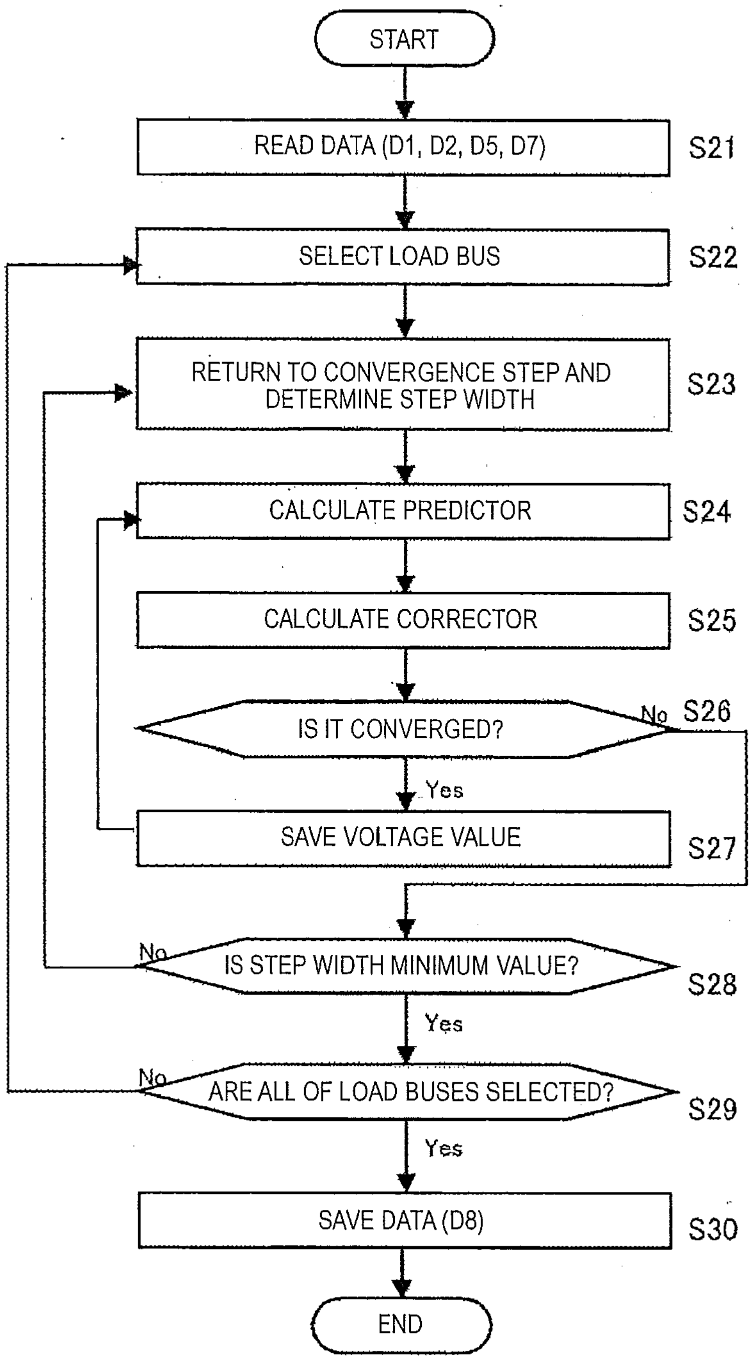
START
READ DATA (D1, D2, D5, D7)
S21
SELECT LOAD BUS
S22
RETURN TO CONVERGENCE STEP AND DETERMINE STEP WIDTH
S23
CALCULATE PREDICTOR
S24
CALCULATE CORRECTOR
S25
IS IT CONVERGED?
No
S26
Yes
SAVE VOLTAGE VALUE
S27
No
IS STEP WIDTH MINIMUM VALUE?
S28
Yes
No
ARE ALL OF LOAD BUSES SELECTED?
S29
Yes
SAVE DATA (D8)
S30
END

[Fig. 11]

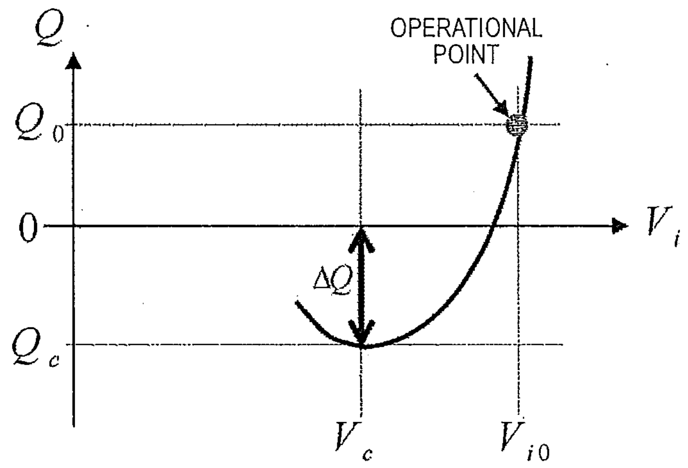


[Fig. 12]

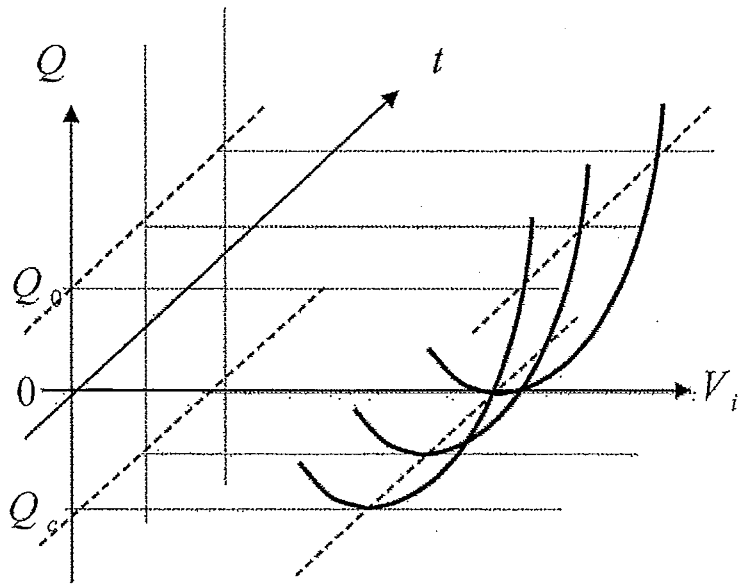

[Fig. 13]

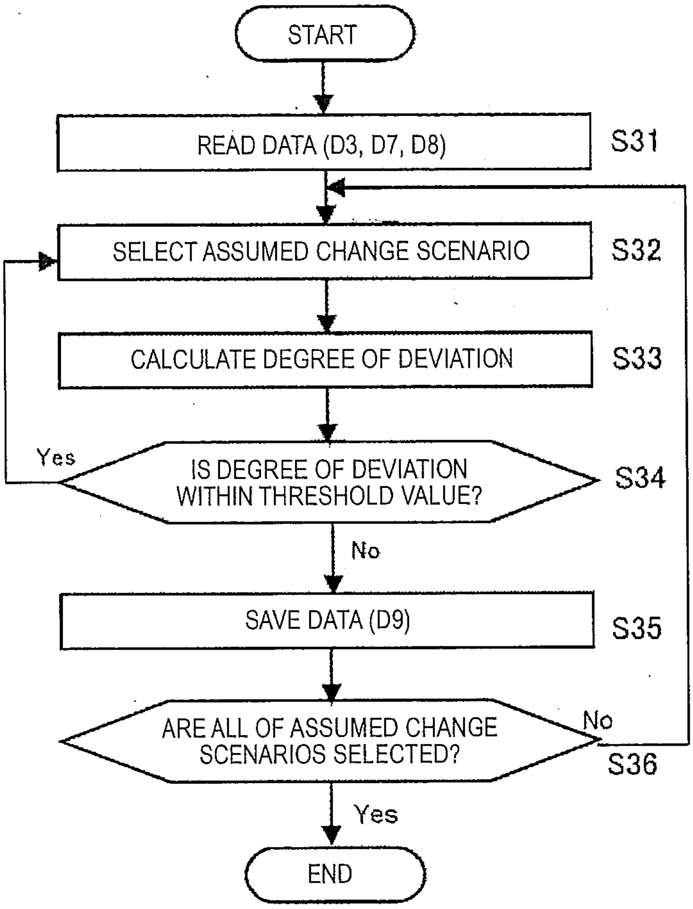
START
READ DATA (D3, D7, D8)
S31
SELECT ASSUMED CHANGE SCENARIO
S32
CALCULATE DEGREE OF DEVIATION
S33
IS DEGREE OF DEVIATION WITHIN THRESHOLD VALUE?
S34
Yes
No
SAVE DATA (D9)
S35
ARE ALL OF ASSUMED CHANGE SCENARIOS SELECTED?
S36
No
Yes
END

[Fig. 14]

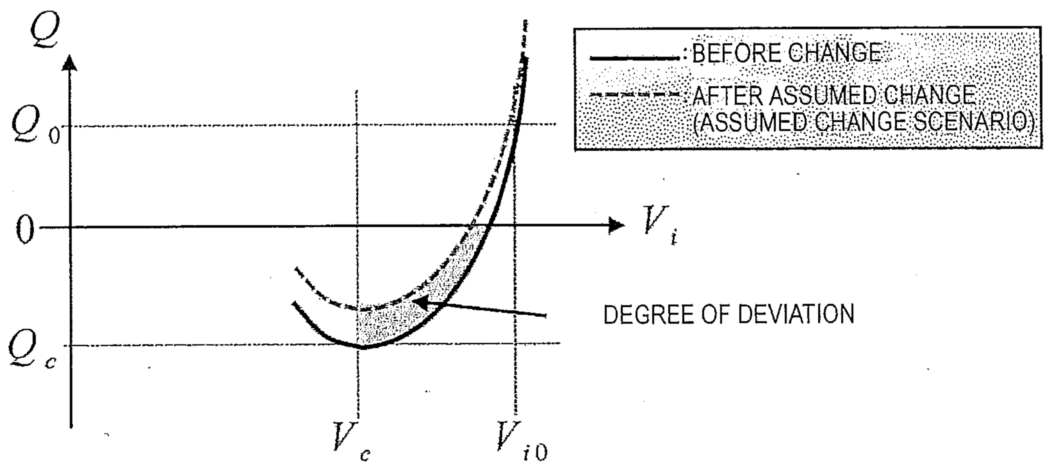
Q
Q0
0
Qc
Vi
Vc
Vi0
: BEFORE CHANGE
: AFTER ASSUMED CHANGE (ASSUMED CHANGE SCENARIO)
DEGREE OF DEVIATION

[Fig. 15]

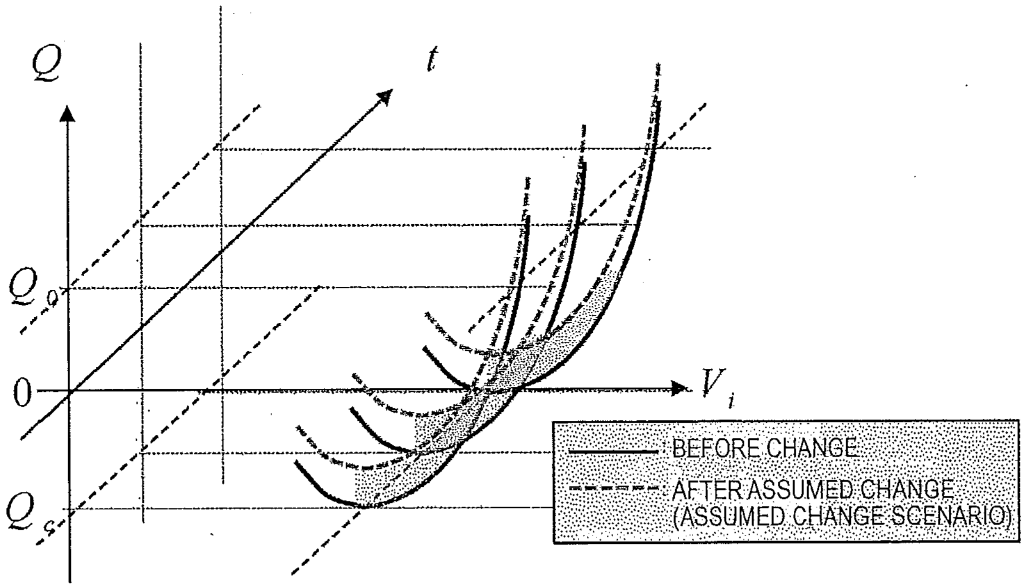
Q
t
$Q_0$
0
$V_i$
$Q_S$
BEFORE CHANGE
AFTER ASSUMED CHANGE
(ASSUMED CHANGE SCENARIO)

[Fig. 16]

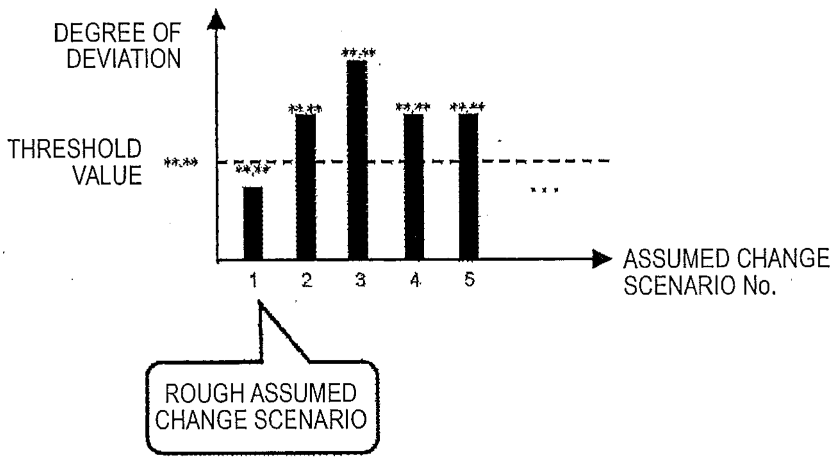
DEGREE OF DEVIATION
THRESHOLD VALUE
**.**
...
ASSUMED CHANGE SCENARIO No.
1
2
3
4
5
ROUGH ASSUMED CHANGE SCENARIO

[Fig. 17]

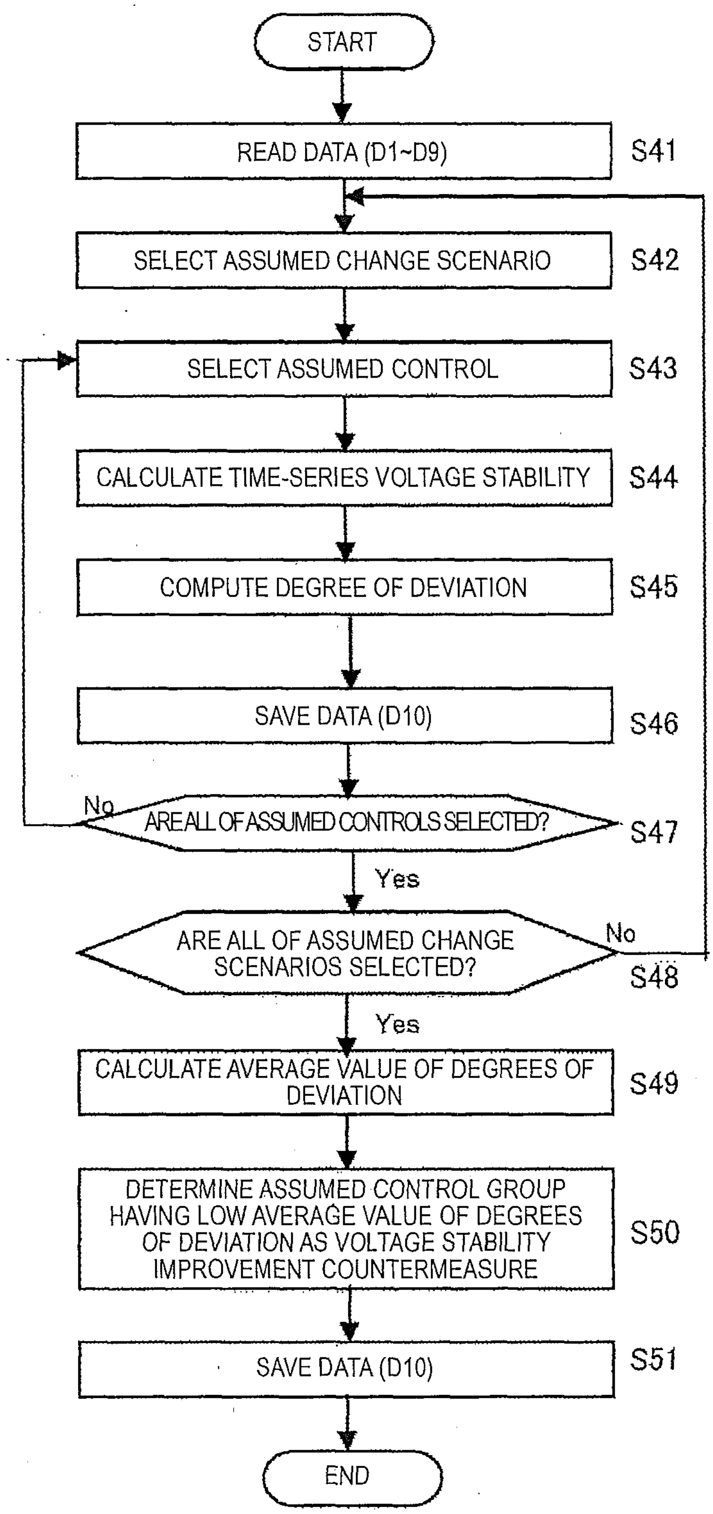
START
READ DATA (D1~D9)
S41
SELECT ASSUMED CHANGE SCENARIO
S42
SELECT ASSUMED CONTROL
S43
CALCULATE TIME-SERIES VOLTAGE STABILITY
S44
COMPUTE DEGREE OF DEVIATION
S45
SAVE DATA (D10)
S46
ARE ALL OF ASSUMED CONTROLS SELECTED?
No
Yes
S47
ARE ALL OF ASSUMED CHANGE SCENARIOS SELECTED?
No
Yes
S48
CALCULATE AVERAGE VALUE OF DEGREES OF DEVIATION
S49
DETERMINE ASSUMED CONTROL GROUP HAVING LOW AVERAGE VALUE OF DEGREES OF DEVIATION AS VOLTAGE STABILITY IMPROVEMENT COUNTERMEASURE
S50
SAVE DATA (D10)
S51
END

[Fig. 18]

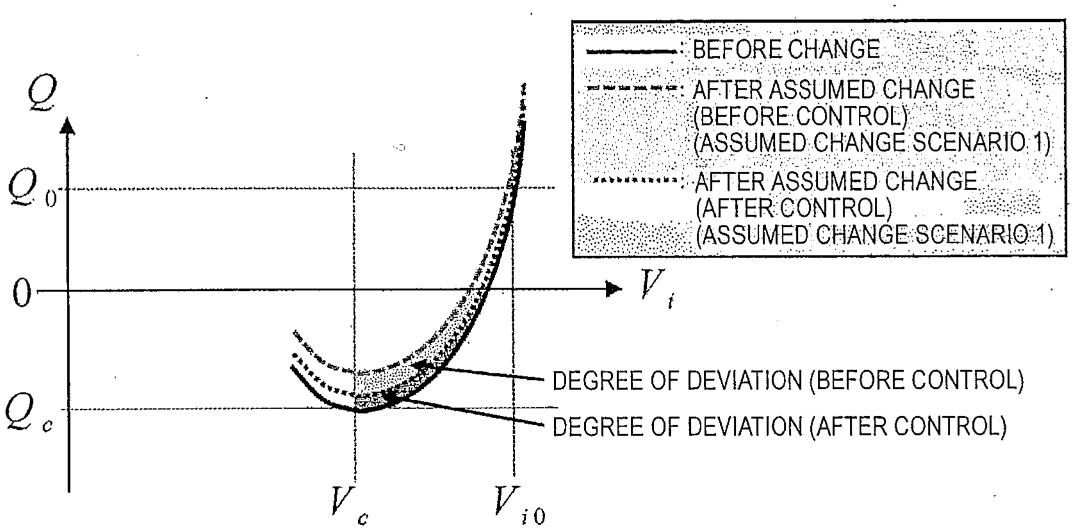

Q
$Q_0$
0
$Q_c$
$V_i$
$V_c$
$V_{i0}$
: BEFORE CHANGE
: AFTER ASSUMED CHANGE (BEFORE CONTROL) (ASSUMED CHANGE SCENARIO 1)
: AFTER ASSUMED CHANGE (AFTER CONTROL) (ASSUMED CHANGE SCENARIO 1)
DEGREE OF DEVIATION (BEFORE CONTROL)
DEGREE OF DEVIATION (AFTER CONTROL)


[Fig. 19]

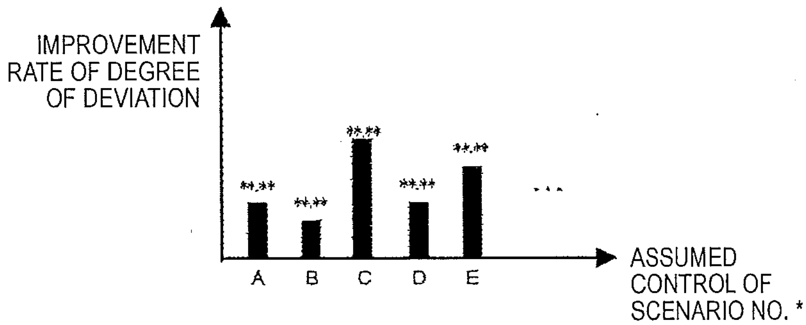

IMPROVEMENT RATE OF DEGREE OF DEVIATION
**.**
A
B
C
D
E
ASSUMED CONTROL OF SCENARIO NO. *

[Fig. 20]

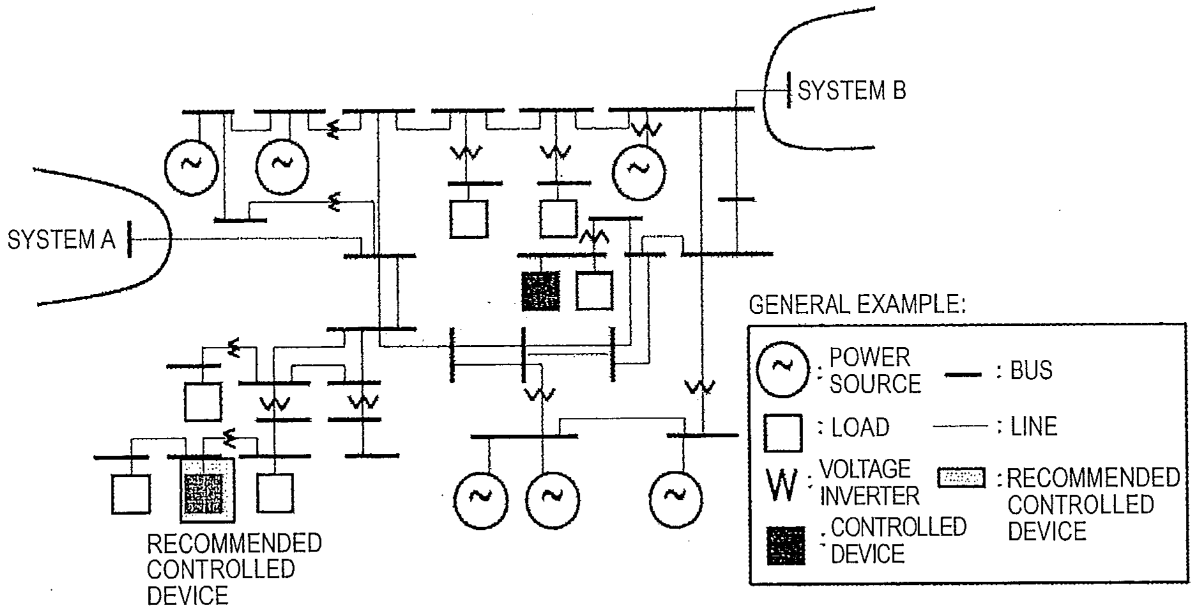
SYSTEM B
SYSTEM A
RECOMMENDED CONTROLLED DEVICE
GENERAL EXAMPLE:
: POWER SOURCE
: BUS
: LOAD
: LINE
W : VOLTAGE INVERTER
: RECOMMENDED CONTROLLED DEVICE
: CONTROLLED DEVICE

[Fig. 21]

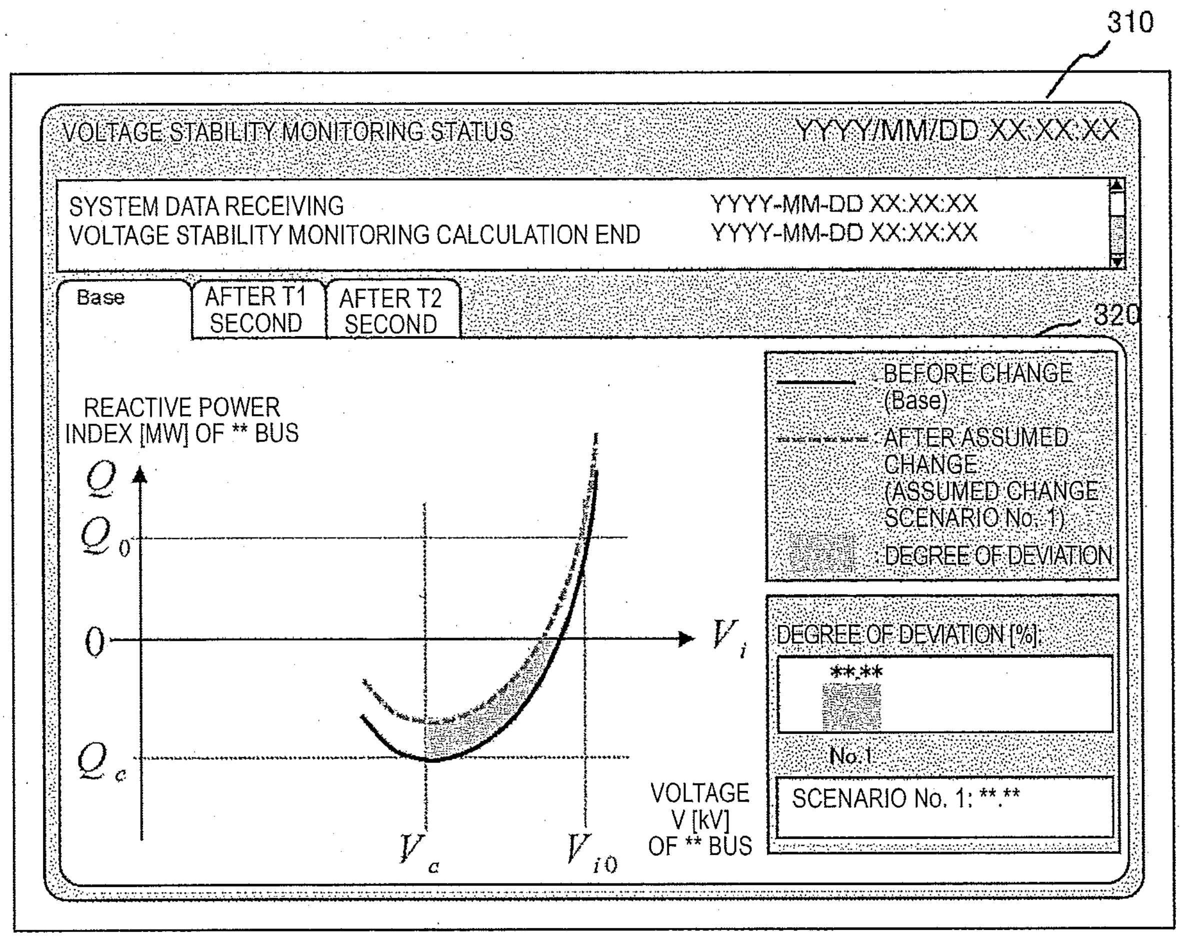
310
VOLTAGE STABILITY MONITORING STATUS
YYYY/MM/DD XX:XX:XX
SYSTEM DATA RECEIVING
YYYY-MM-DD XX:XX:XX
VOLTAGE STABILITY MONITORING CALCULATION END
YYYY-MM-DD XX:XX:XX
Base
AFTER T1 SECOND
AFTER T2 SECOND
320
REACTIVE POWER INDEX [MW] OF ** BUS
Q
Q0
0
Qc
Vi
Vc
Vi0
VOLTAGE V [kV] OF ** BUS
BEFORE CHANGE (Base)
AFTER ASSUMED CHANGE (ASSUMED CHANGE SCENARIO No. 1)
DEGREE OF DEVIATION
DEGREE OF DEVIATION [%]:
**.**
No.1
SCENARIO No. 1: **.**

[Fig. 22]

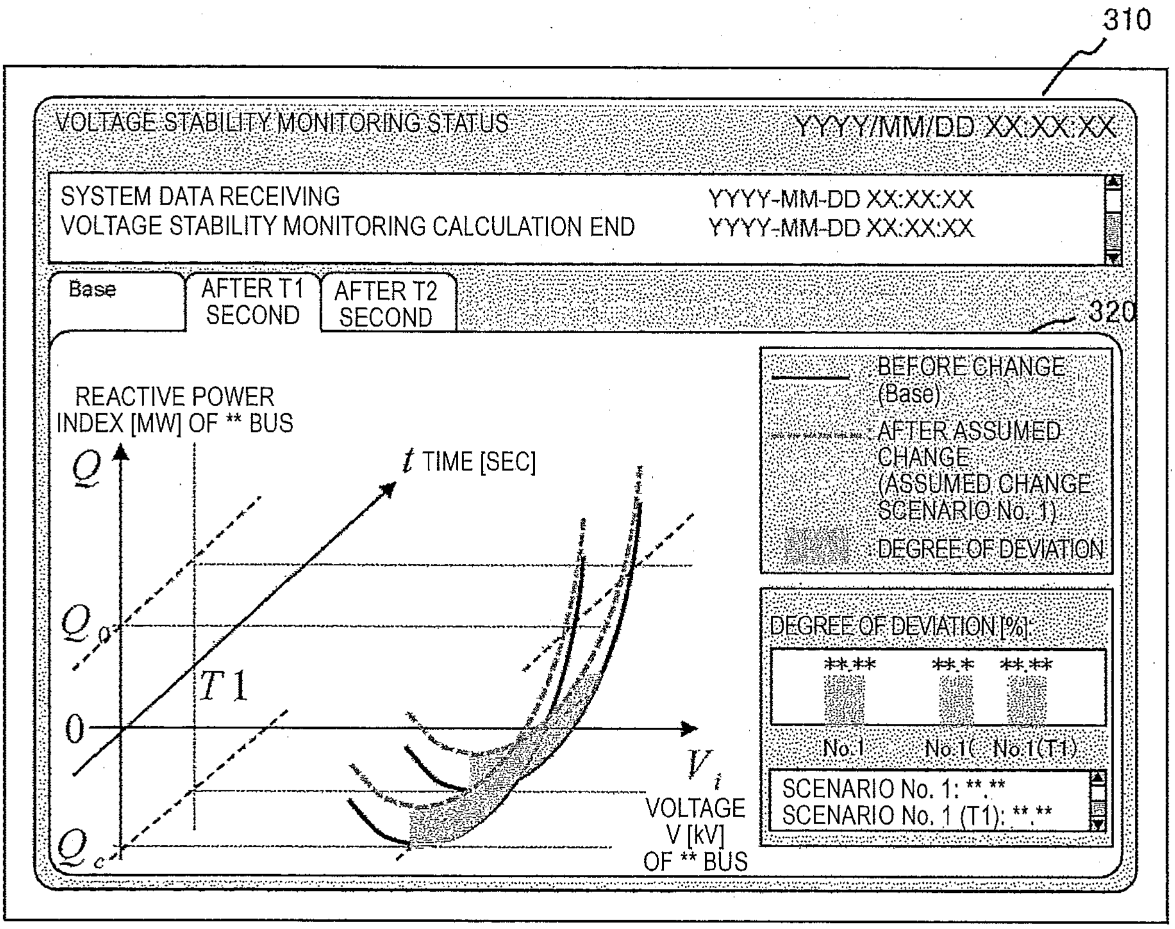
310
VOLTAGE STABILITY MONITORING STATUS
YYYY/MM/DD XX:XX:XX
SYSTEM DATA RECEIVING
YYYY-MM-DD XX:XX:XX
VOLTAGE STABILITY MONITORING CALCULATION END
YYYY-MM-DD XX:XX:XX
Base
AFTER T1 SECOND
AFTER T2 SECOND
320
REACTIVE POWER INDEX [MW] OF ** BUS
Q
t TIME [SEC]
Q0
T1
0
Vi
VOLTAGE V [kV] OF ** BUS
Qc
BEFORE CHANGE (Base)
AFTER ASSUMED CHANGE (ASSUMED CHANGE SCENARIO No. 1)
DEGREE OF DEVIATION
DEGREE OF DEVIATION [%]
**.**
**.*
**.**
No.1
No.1(
No.1(T1)
SCENARIO No. 1: **.**
SCENARIO No. 1 (T1): **.**

[Fig. 23]

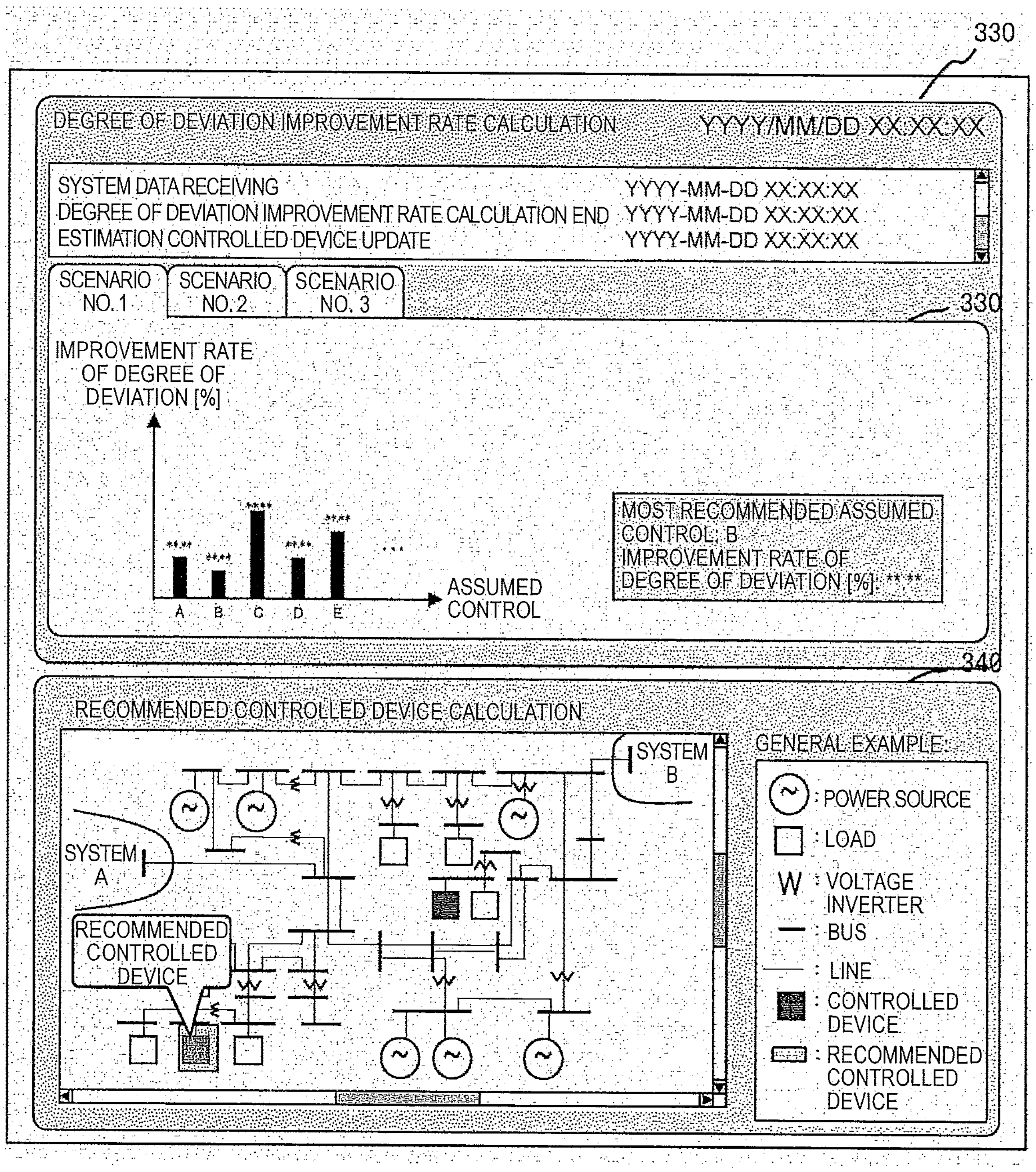
330
DEGREE OF DEVIATION IMPROVEMENT RATE CALCULATION
YYYY/MM/DD XX:XX:XX
SYSTEM DATA RECEIVING YYYY-MM-DD XX:XX:XX
DEGREE OF DEVIATION IMPROVEMENT RATE CALCULATION END YYYY-MM-DD XX:XX:XX
ESTIMATION CONTROLLED DEVICE UPDATE YYYY-MM-DD XX:XX:XX
SCENARIO NO. 1
SCENARIO NO. 2
SCENARIO NO. 3
330
IMPROVEMENT RATE OF DEGREE OF DEVIATION [%]
A B C D E
ASSUMED CONTROL
MOST RECOMMENDED ASSUMED CONTROL: B
IMPROVEMENT RATE OF DEGREE OF DEVIATION [%]: **.**
340
RECOMMENDED CONTROLLED DEVICE CALCULATION
SYSTEM A
SYSTEM B
RECOMMENDED CONTROLLED DEVICE
GENERAL EXAMPLE:
: POWER SOURCE
: LOAD
W : VOLTAGE INVERTER
: BUS
: LINE
: CONTROLLED DEVICE
: RECOMMENDED CONTROLLED DEVICE

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 7163053 A
- JP 2011115024 A
- JP 2005287128 A
- JP 9512698 A
- JP 9512699 A
- US 2014148962 A1
- JP H07163053 A
- JP 6153397 A


### Non-patent literature cited in the description


- **SUZUKI MAMORU ; KISHIDA YUKIO.** Voltage Stability Online Monitoring System. *Electrical Engineers of Japan. B,* 1991, vol. 111 (3
- Voltage Stability Criteria, Undervoltage Load Shedding Strategy, and Reactive Power Reserve Monitoring Methodology. Final Report. WECC, 1998
- Power system Stability Operational Technique. the electric cooperative research. Power System Stability Operation Technical Committee, 1991, vol. 47, 24-34
- **LARS HOLTEN ; ANDERS GJELSVLK ; SVERRE ADAM ; F.F. WU ; WEN-HS IUNG E. LIU.** Comparison of Different Methods for State Estimation. *IEEE Transaction on Power Systems,* 1988, vol. 3, 1798-1806
- **CHIANG, H.D et al.** CPFLOW: A Practical Tool for Tracing Power System Steady-State Stationary Behavior Due to Load and Generation Variations. *IEEE Trans. on Power Systems,* 1995, vol. 10 (2
- **VVENKATARAMANA AJJARAP.** Computational Techniques for Voltage Stability Assessment and Control. Springer, 2006, 49-116
- **WECC.** Voltage Stability Criteria, Under voltage Load Shedding Strategy, and Reactive Power Reserve Monitoring Methodology. *Final Report,* 1998, 33-58
- **WILLIAM. F. TINNEY et al.** Power Flow Solution by Newton's Method. *IEEE Trans. on Power Systems,* 1967, vol. PAS-86 (11), 1449-1460